# EUROPEAN PATENT SPECIFICATION

(11) **EP 0 715 152 B1**
(45) Date of publication and mention of the grant of the patent: **10.11.1999**
(21) Application number: 95118661.8
(22) Date of filing: 27.11.1995
(51) Int. Cl.: G01D 5/20, H03K 17/95, G01R 27/02

(54) **A high frequency type sensing device**
Hochfrequenzsensoranordnung
Dispositif de détection à haute fréquence

(30) Priority: 30.11.1994 JP 29628094; 25.05.1995 JP 12658595
(43) Date of publication of application: 05.06.1996
(73) Proprietor: OMRON CORPORATION, Kyoto-shi, Kyoto 616-8025 (JP)
(72) Inventor: Kasai, Eiji, c/o Omron Corporation, Shimokaiinji, Nagaokakyo-City, Kyoto 617 (JP); Katoh, Akinori, c/o Omron Corporation, Shimokaiinji, Nagaokakyo-City, Kyoto 617 (JP); Inagami, Misako, c/o Omron Corporation, Shimokaiinji, Nagaokakyo-City, Kyoto 617 (JP)
(74) Representative: WILHELMS, KILIAN & PARTNER Patentanwälte

(56) References cited:
- FR-A- 2 630 238
- US-A- 4 262 246
- US-A- 4 646 066
- PATENT ABSTRACTS OF JAPAN vol. 9 no. 75 (E-306) ,4 April 1985 & JP-A-59 208902 (TATEISHI DENKI KK) 27 November 1984,
- PATENT ABSTRACTS OF JAPAN vol. 16 no. 396 (P-1407) ,21 August 1992 & JP-A-04 130236 (YASKAWA ELECTRIC CORP) 1 May 1992,
- JOURNAL OF VACUUM SCIENCE & TECHNOLOGY B, vol. 12, no. 1, January 1994 - February 1994 WOODBURY,NJ, US, pages 395-398, XP 000429047 BHIMNATHWALA ET AL. 'Measurement of the sheet resistance of doped layers in semiconductors by microwave reflection'

## Description

### BACKGROUND OF THE INVENTION

### 1. Field of the Invention

This invention relates to a sensing device employing a high frequency signal for sensing an object, and more particularly to an improved device capable of sensing the presence or absence of various articles such as material, liquid, powder and the human body and kinds thereof.

### 2. Discussion of the Related Art

Conventional sensing devices for sensing the presence or absence and the kind of material and liquid are represented by a device employing an electrical conductive method for detecting a voltage drop of an electricity applied to the material or a dielectric method by contacting the same, a proximity switch, a photoelectric switch and an ultrasonic switch. Conventional sensing devices for sensing the presence or absence of the human body are represented by a weight sensor for measuring the weight, an electrostatic capacity sensor utilizing an electrostatic capacity varying with the approach of the human body, a photo sensor for detecting the reflection or interruption by the human body, an infrared sensor, and an ultrasonic sensor.

As a sensing method for detecting a concentration of salt in liquid there have been proposed heretofore an electric conductive method for putting an electrode into liquid and applying electricity thereto to measure a voltage drop therein, a dielectric method by contacting the liquid, and a method for radiating an ultrasonic wave and measuring a degree of its reflection from a reflector.

According to the conventional sensing devices and methods, it is impossible to precisely detect material or liquid contained in a small opaque container without any contact therewith. Particularly in the conventional electrical conductive method and dielectric method an article or substance to be measured thereby should be contacted and light is necessary to penetrate the container. Moreover it is impossible for the ultrasonic sensor to measure a small container. The electrical conductive, light and ultrasonic methods cannot perform the identification of the kind of an article.

A conventional proximity switch employing a high frequency is designed to detect metal having a high magnetic permeability. The switch employs a self-excited oscillation, in which a high frequency oscillation coil itself is a sensor and an impedance of the coil varies or the oscillation stops or starts as a metal approaches the coil. This switch, however, cannot detect an article or substance having a low magnetic permeability.

The above-mentioned conventional sensors cannot discriminate the human body at a standstill from a piece of baggage. The weight sensor erroneously identifies heavy baggage seated on the sensor as the human body. The photo sensor erroneously identifies the presence of an object whenever light is interrupted by any material. The ultrasonic sensor erroneously identifies the presence of an object whenever the ultrasonic wave is reflected by any material. The infrared sensor has the disadvantage that the motion of an object is judged to be the presence of human body and the human body at a standstill is ignored.

An electrostatic capacitive sensor installed in a chair is conventionally used, but sensible to external conditions. If a foot separates from a floor, the sensor is erroneously operated. A child not reaching the floor sits on the chair cannot be detected.

According to the conventional liquid concentration detecting method, an electrode or a reflector is necessary to be put into the liquid and the detection cannot be performed without contact with the liquid. Washing the electrode and the reflector is necessary prior to every measurement, and unfavorably takes time for many processes made in continuing measurement. This method also has the disadvantage that the electrode or the reflector corrodes due to salt. The method employing an ultrasonic wave cannot perform the measurement unless the container has a diameter larger than 5 cm.

A sensing device according to the preamble of claim 1 is known from US-A-4 646 066.

### SUMMARY OF THE INVENTION

It is, therefore, a primary object of this invention to provide an improved sensing device and method capable of accurately sensing an article substance such as liquid, powder and so forth in addition to metal whether transparent or opaque, and moreover of sensing the kind of the article.

It is a further object of this invention to provide a human body sensing device and method capable of precisely sensing the human body at a standstill by discriminating the human body from other substances, and a substance sensing device capable of sensing other articles than the human body.

It is a still further object of this invention to provide a liquid concentration sensing device and method of easily measuring a concentration of liquid without any contact therewith in a short measuring time, which is free from worrying any corrosion of electrodes.

According to the invention there is provided a sensing device as defined in claim 1.

When the sensing device further employs a troidal core wound by a coil, a magnetic flux density in air between ends of the core is so high that the detection sensitivity of a substance and a material can be high. When the sensing device further employs a transformer for supplying a resonance circuit with electric power, the imaginary part of an impedance of the sensor can be zero and the real part can be set to a predetermined value.

### BRIEF DESCRIPTION OF THE DRAWINGS

Other objectives and advantages of this invention will be more readily apparent from the following detailed description provided in conjunction with the following figures, of which:
Fig. 1 is a schematic circuit diagram of a substance sensing device as a first embodiment of this invention;
Fig. 2 is a circuit of a sensor employed in the sensing device of Fig. 1;
Fig. 3 shows a detection coil wound around a troidal core;
Fig. 4 is a schematic block diagram of a sensing device as a modification of the sensing device of Fig. 1;
Fig. 5 is a graph showing a reflection characteristic of the sensor of Fig. 1;
Fig. 6 shows the sensing device of Fig. 1 sensing a liquid level within a container without a lid;
Fig. 7 shows the sensing device of Fig. 1 sensing a liquid level within a container with a lid;
Fig. 8 shows the sensing device of Fig. 1 sensing a liquid level within an opaque container;
Fig. 9 shows the sensing device of Fig. 1 sensing a liquid level within a container with a label;
Fig. 10 shows the sensing device sensing horizontal liquid boundaries of an oleaginous solution and an aqueous solution;
Fig. 11 shows the sensing device sensing liquid boundaries where a mixed layer between an oleaginous solution and an aqueous solution;
Fig. 12 shows the sensing device sensing a horizontal liquid boundary between a liquid and a solid;
Fig. 13 shows the sensing device sensing a deformed liquid boundary between a liquid and a solid;
Fig. 14 shows the sensing device sensing a liquid level having bubbles;
Fig. 15(a) is a graph showing the relation between an output of the sensing device and a distance from a measured sample to the sensor of the sensing device and Fig. 15(b) shows the sensing device sensing the measured sample;
Fig. 16 is a circuit diagram of a liquid concentration sensing device as a second embodiment of this invention;
Fig. 17 is a graph of a detection voltage characteristic of the sensing device of Fig. 16 about a liquid concentration;
Fig. 18 is a circuit diagram of a liquid concentration sensing device as a third embodiment of this invention;
Fig. 19 is a graph showing a detection voltage at each different temperature in the sensing device of Fig. 18;
Fig. 20 is a circuit diagram of a liquid concentration sensing device as a fourth embodiment of this invention;
Fig. 21 is a circuit diagram of a liquid concentration sensing device as a fifth embodiment of this invention;
Fig. 22 is a circuit diagram of a human body sensing device as a sixth embodiment of this invention;
Fig. 23 is a detection coil employed in the sensing device of Fig. 22;
Fig. 24 is a modification of the detection coil of Fig. 23;
Fig. 25 is another detection coil which may be employed in the human body sensing device of Fig. 22;
Fig. 26 shows a seat in which the human body sensing device is installed;
Fig. 27 shows a cushion installed by the sensing device;
Fig. 28 is a circuit diagram of a human body sensing device as a seventh embodiment of this invention;
Fig. 29 is a graph showing relation between a frequency of an oscillator of the human body sensing device and a reflected wave when the seat is vacancy, or seated by a child, an adult or a baggage;
Fig. 30 is a frequency vs. reflected wave characteristic to explain a detection operation about the human body by the sensing device;
Fig. 31 is a flow chart to showing an seating detection operation by the human body sensing device;
Fig. 32 is a circuit diagram of a human body sensing device as an eighth embodiment of this invention;
Fig. 33 is a circuit diagram of a powder sensing device as a ninth embodiment of this invention;
Fig. 34 shows the powder sensing device of Fig. 33 sensing wheat flour;
Fig. 35 shows relation between a position of a sensor of the powder sensing device sensing refined sugar within a container and an output voltage of the sensing device;
Fig. 36 shows relation between a position of the sensor sensing cocoa within a container and an output voltage of the sensing device;
Fig. 37 shows relation between a position of the sensor sensing coffee powder within a container and an output voltage of the sensing device;
Fig. 38 shows relation between a position of the sensor sensing skim milk within a container and an output voltage of the sensing device;
Fig. 39 is side view of a mechanism moving up and down the sensor along a tube having a small diameter;
Fig. 40 is an enlarged side view of a sensor section of the mechanism viewed in a view direction;
Fig. 41 is an enlarged side view of a sensor section of the mechanism viewed in other view direction; and
Fig. 42 is an enlarged plane view of the sensor section of the mechanism viewed from the top.

### DETAILED DESCRIPTION OF THE INVENTION

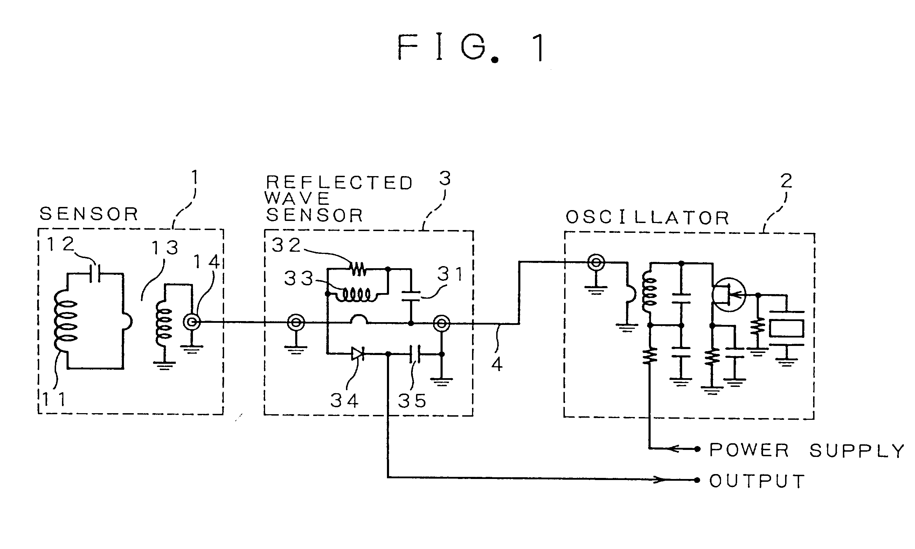

Referring, now, to Fig. 1, there is shown a circuit diagram of a substance sensing device as a first embodiment of this invention, which includes a sensor 1, an oscillator 2 for transmitting a high frequency signal through a transmission path 4 to the sensor 1, and a reflected wave sensor 3 as a detector detecting a reflection signal of the high frequency signal applied to the sensor 1 which is reflected by the sensor 1 and returning toward the oscillator 2. The reflected wave sensor 3 as one example of a detector and the sensor 1 consist of passive elements, not employing any active elements.

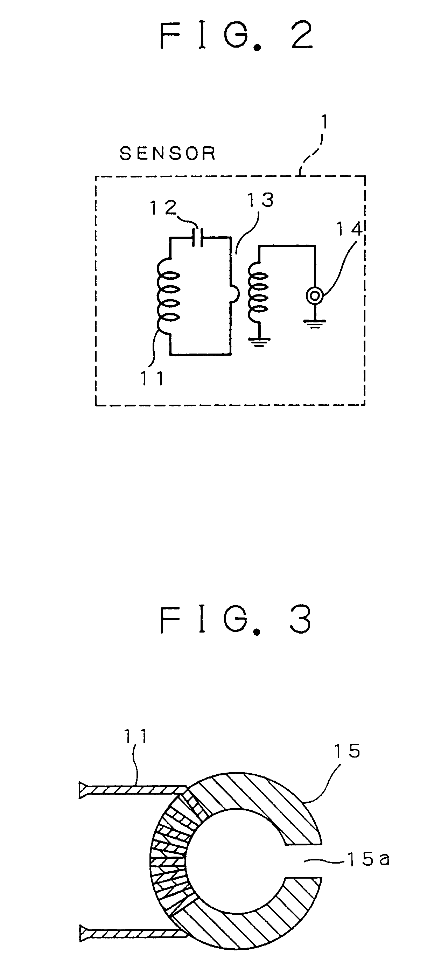

The sensor 1 includes a detection coil 11, a resonance capacitor 12 forming a series resonance circuit with the detection coil 11, and a real number transformer 13 in which a primary coil thereof is connected with the resonance circuit in an input side and a secondary coil thereof is connected with a high frequency input terminal 14 and a ground as also shown in Fig. 2. The resonance circuit may employ a parallel resonance circuit if desired.

The oscillator 2 is an oscillation circuit employing a crystal oscillator. If desired, the oscillation circuit may be other conventional high frequency oscillation circuit such as a LC oscillator or a phase locked loop (PLL). The oscillator 2 generates an output frequency 40.68 MHz, but the output frequency may be designed to be between 10 MHz and 300 MHz suitable for detecting a non-magnetic material and retaining the device in a small size. The reflected wave sensor or detector 3 includes a directional coupler, and detects the reflected wave from the sensor 1 as a power for conversion into a voltage. The sensor 3 includes a capacitor 31 connected with the transmission path 4 and a parallel circuit consisting of a resistor 32 and a coil 33 M-coupled with the transmission path 4. The parallel circuit at one end thereof is connected with the capacitor 31 and at another end thereof is connected with an anode of a diode 34. A cathode of the diode 34 is grounded through a capacitor 35 and externally generates an analog output signal representing a reflected wave converted into a voltage. The reflected wave sensor 3 employs CM coupling, but may employ MM coupling or other sensor if desired.

In this substance sensing device the high frequency signal is applied from the oscillator 2 to the sensor 1 through the transmission path 4. Assuming that a resonance frequency of the resonance circuit is set to coincide with the frequency of the oscillator 2 and that an impedance (an imaginary part is zero and a real part is 50 ohm) of the sensor 1 and an impedance of the transmission path 4 are matched when a circumstance in the absence of a detected substance (or material) is air, the reflection of a transmitted high frequency signal is almost zero and the output from the reflected wave sensor 3 is zero, whereby the absence of the substance to be detected is detected.

When the substance or object exists, the sensor 1 is magnetically influenced by the difference of magnetic permeability of the air and the substance, and the impedance varies. As the impedance of the sensor 1 is largely shifted from the matched impedance, the reflection signal becomes large and is detected by the detector 3 to generate an analog signal corresponding to the variation of the impedance viz. the reflected wave so that the presence of the substance is detected. Thus, the presence or absence of a substance can be detected. For detection of the presence or absence of a substance or material the reflected wave is detected by the detector 3, but the difference of permeability of a substance or material has only to be detected. It may be designed that the numerical value of an imaginary part of the impedance of the resonance circuit is set around zero on resonance in the sensor 1 and an analog signal corresponding to the increase of the imaginary numerical value of the impedance is generated from the detector 3 on detection of the substance or material.

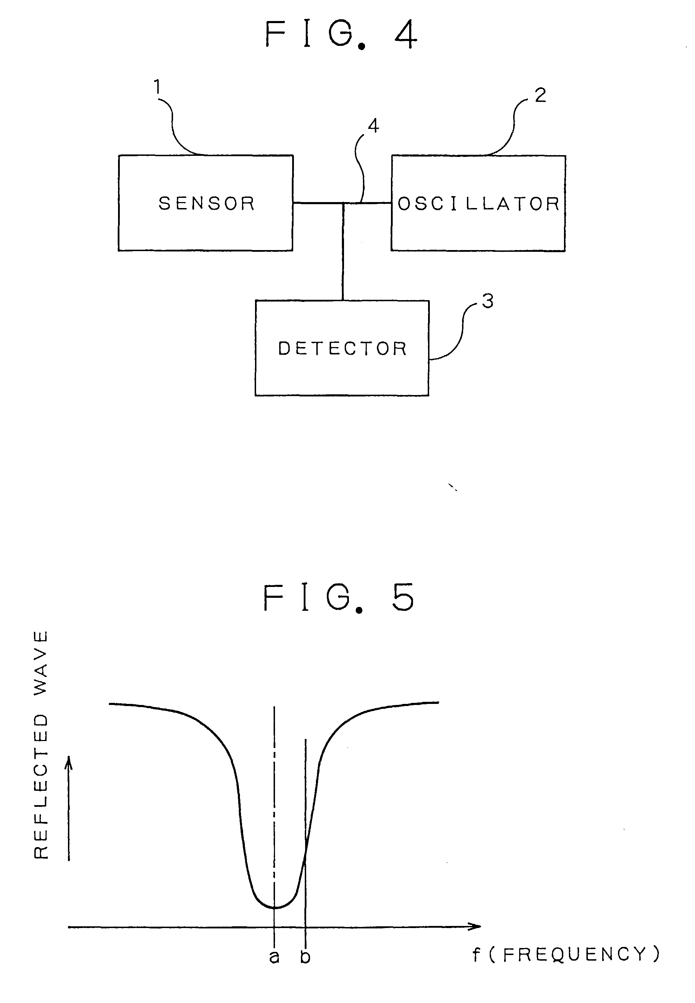

When the reflected wave of the sensing device of this embodiment is employed for judgement of a material or liquid having a low magnetic permeability, the variation of the reflected wave itself is extremely small and the change of the output voltage corresponding to the reflected wave also becomes small if measured from the minimum point of the reflected wave as shown at a point "a" of Fig. 5 showing a reflection characteristic of the sensor of Fig. 1. Accordingly, if the measurement is initiated from a reflection point (for instance a point "b" of Fig. 5) providing the largest slope within 80% in the curve of Fig. 5, the variation of the output voltage about the reflected wave becomes large and the sensitivity of the sensor becomes high. In this case, the oscillation frequency of the oscillator 2 is designed to be shifted from the resonance frequency of the sensor 1 to a frequency at a steep slope point of the resonance characteristic.

The detection coil 11 of the sensor 1 does not employ an air-core coil, but a coil wound around a C-shaped core as shown in Fig. 3 which is formed by cutting a portion 15a from a troidal core 15 so that magnetic fluxes can be concentrated and the reduction of a leaking magnetic field and increase of the sensitivity can be obtained. By changing the form or size of the cut portion 15a various material and liquid can be precisely detected.

As a modification of the sensing device of the first embodiment in which a reflected power is detected and the presence or absence of or the kind of a substance is detected based on the magnitude of the reflected power, Fig. 4 shows a circuit block diagram of a sensing device. Detector 3 detects at least one of a phase, a voltage and a current of a reflected wave on transmission path 4 between sensor 1 and oscillator 2 to generate a signal which can be processed like converted into a reflected power. By mounting the oscillator 2 and the detector 3 on a same board, connecting the sensor 1 with the detector 3 by a cable, and arranging sensor 1 separated and independent from the oscillator 2 and detector 3, the degree of freedom about a mounting position of the sensor 1 is increased and the sensor 1 can be easily replaced.

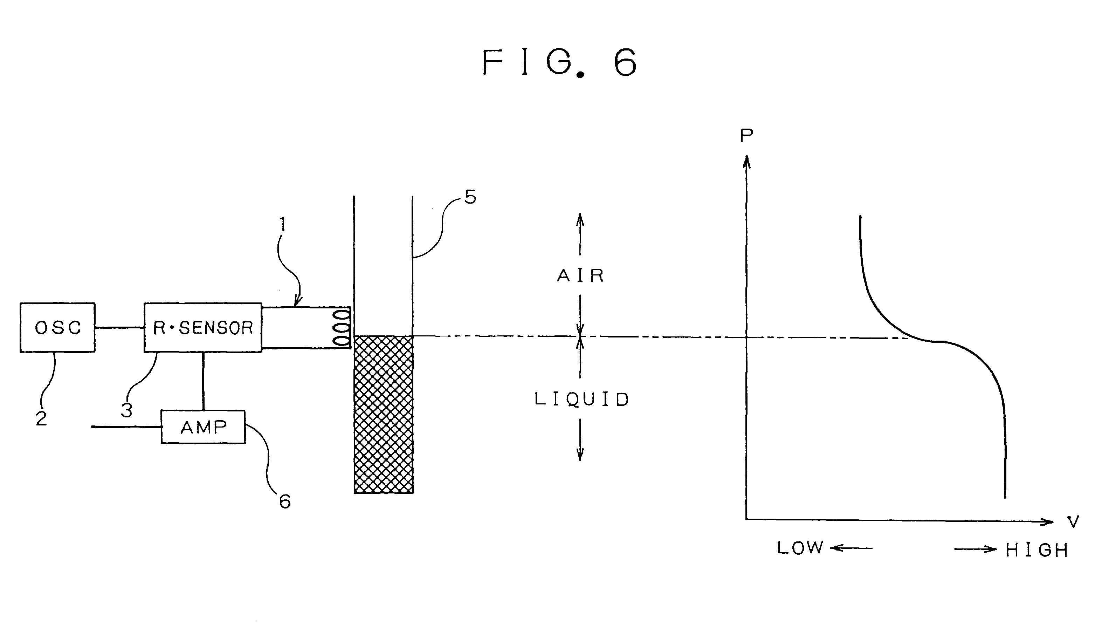

Applications of the sensing device of Fig. 1 will be described hereinafter. Figs. 6 to 14 at left and right hand sides show schematic views of the sensing device of Fig. 1 and relation between an output signal V of the reflected wave sensor 3 and a position P of the sensor 1, in which corresponding positions are shown in two-dotted lines. For detection of the presence or absence of liquid, a voltage value at a point of a curve at a right hand side crossing the two-dotted line is designed to be a threshold value for level discrimination. This threshold value is set to a level discriminating means of a processor (not shown in Fig. 1) receiving the output from the reflected wave sensor 3 of Fig. 1. For detection of a boundary, the output of the reflected wave sensor 3 is read by CPU or the like by sampling, and a time point when the output makes a large variation is detected.

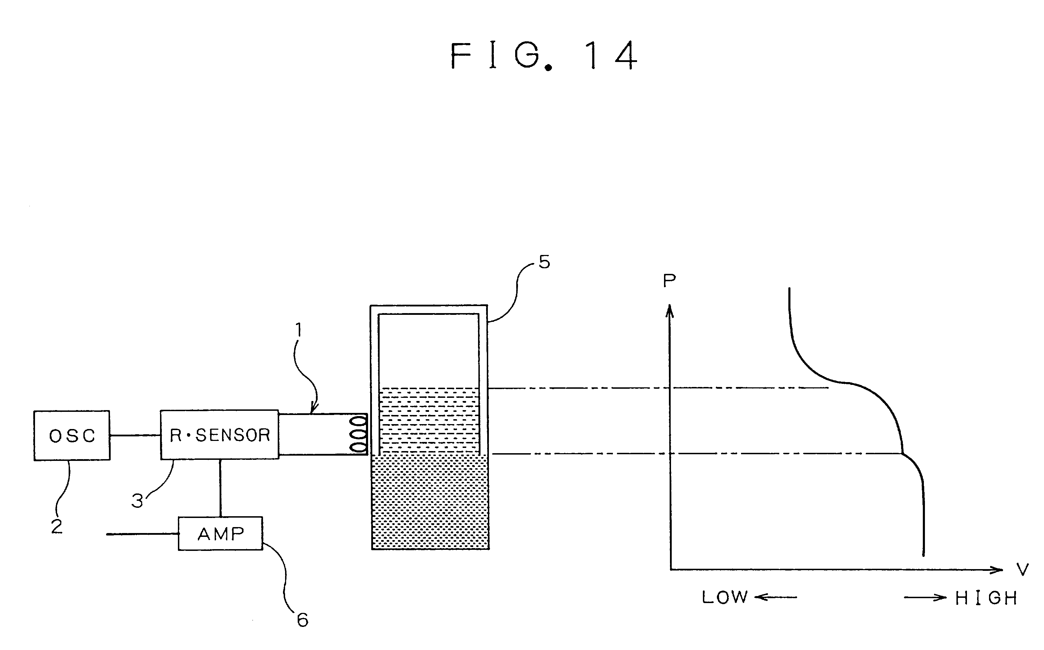

Liquid, oil and solid in Figs. 6 to 13 are water, olive oil and eraser, and liquid and bubbles of Fig. 14 are liquid, detergent and its bubbles. Fig. 6 shows detection of a liquid level within a container 5 having no lid. As the sensor 1 is lowered along an external side of the container 5 from the top, the output voltage V from the reflected wave sensor 3 through an amplifier 6 has a characteristic as shown by a curve at a right hand side of Fig. 6. The point where the output voltage largely changes corresponds to a boundary surface between air and liquid, viz. a liquid level.

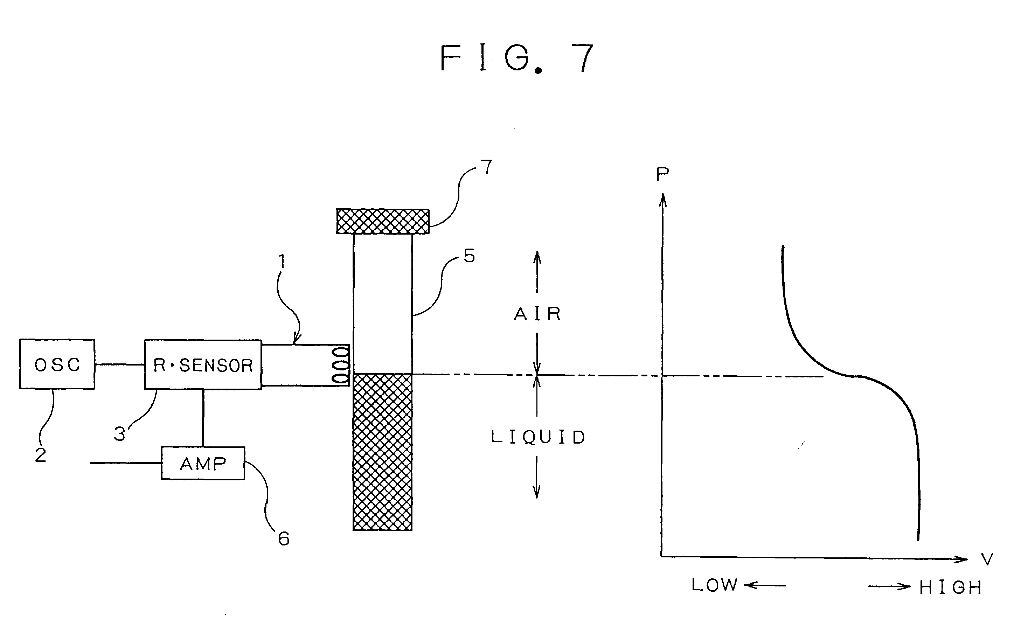

Fig. 7 shows detection of a liquid level within a container 5 closed by a lid 7. If the container is not transparent, inside of the container cannot be seen from outside, so that the liquid level cannot be found by human eyes. As shown in Fig. 7, however, the liquid level in the opaque container can be detected by the same operation as that of Fig. 6.

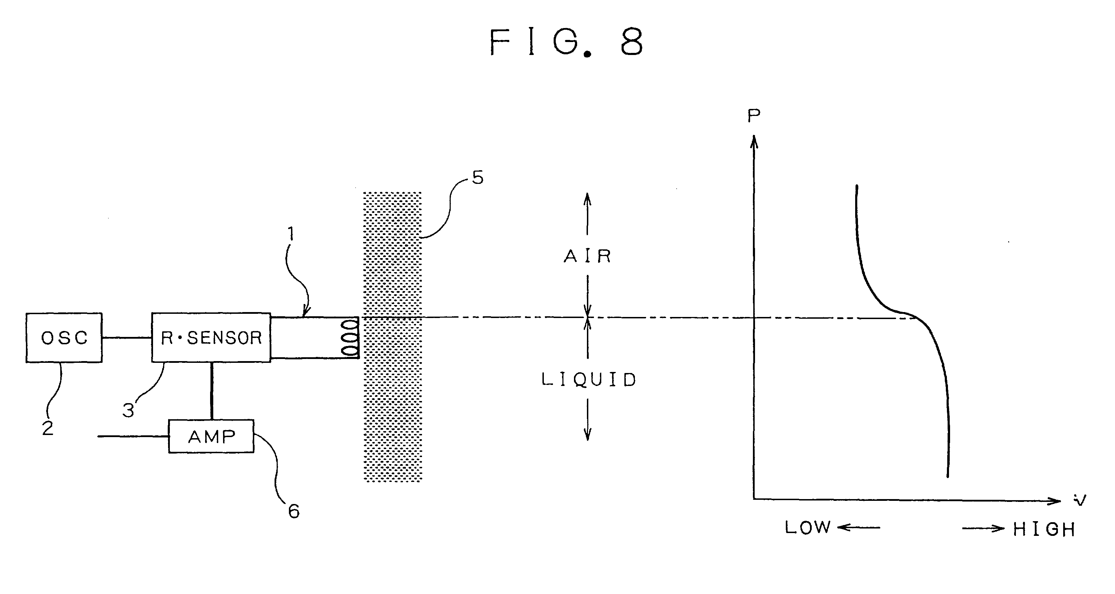

Fig. 8 shows detection of a liquid level within an opaque container 5. As the sensor 1 is lowered from top to bottom along an external side wall of the container, a position of the sensor 1 where the output voltage V from the amplifier 6 suddenly varies is found as a liquid level.

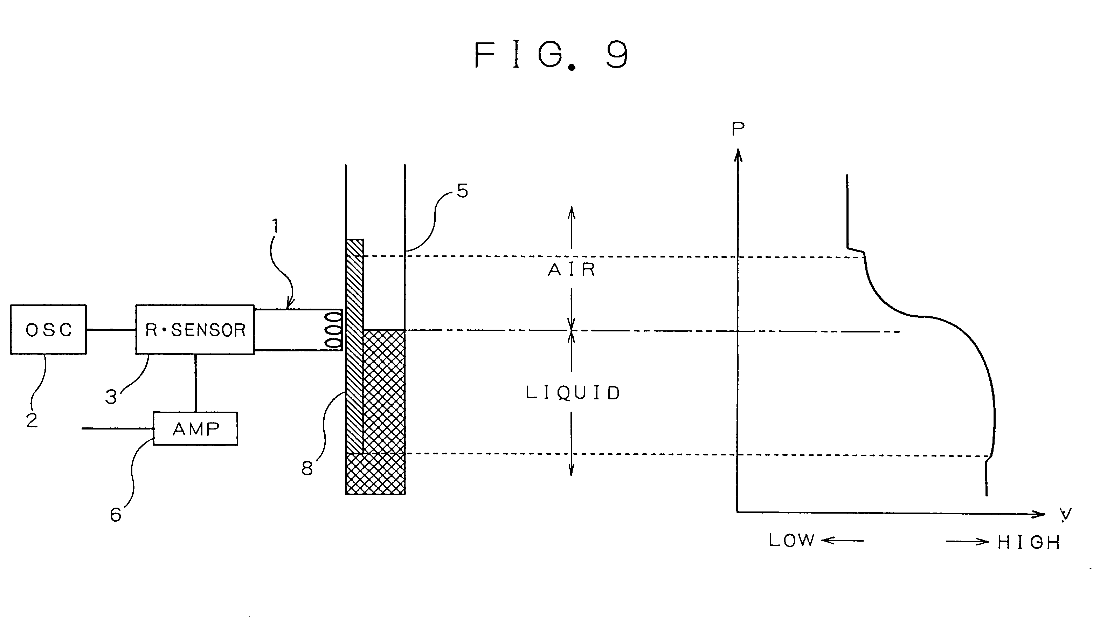

Fig. 9 shows detection of a liquid level within a container 5 with a label 8. The label 8 is adhered to a side wall of the container 5, and the liquid level cannot be seen by blockage of the label 8. As the sensor 1 is lowered from top to bottom along the label 8 as shown in Fig. 9, however, the output voltage V from the amplifier 6 is shown by a curve of Fig. 9 at a right hand side and a position of the sensor 1 where the output suddenly varies at a center is found as a liquid level.

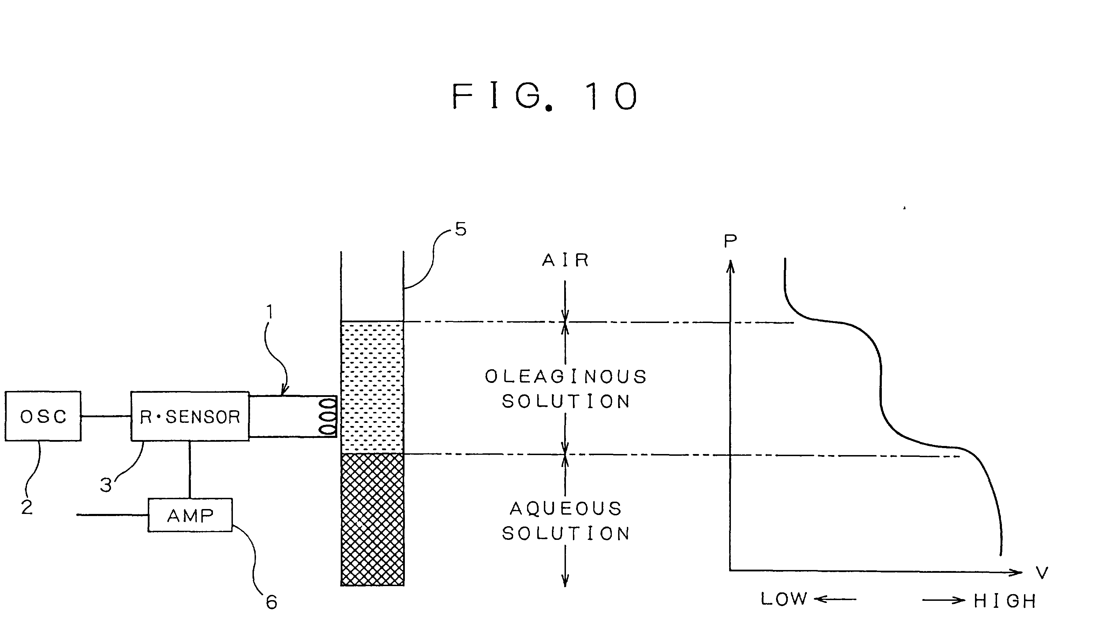

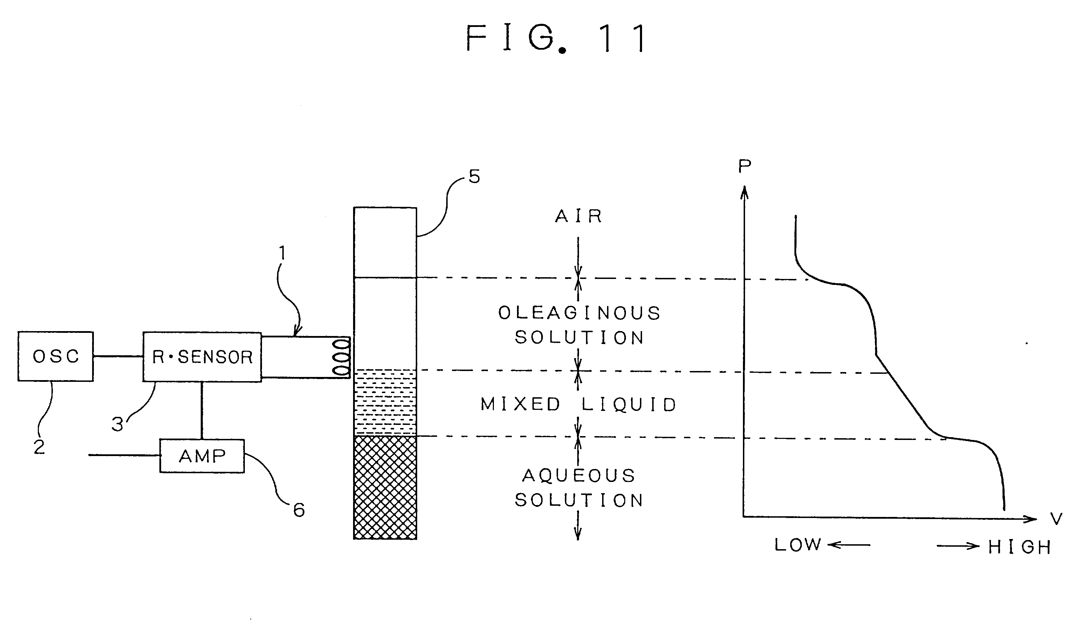

Fig. 10 shows detection of liquid boundaries of an oleaginous solution and an aqueous solution where the liquid boundaries are flat and horizontal. As the sensor 1 is lowered from the top of the container 5 to the bottom, the output voltage V from the amplifier 6 is shown by a curve of Fig. 10 in which an upper steep slope of the output voltage corresponds to a boundary between air and the oleaginous solution and a lower steep slope of the output voltage corresponds to a boundary between the oleaginous solution and the aqueous solution. As there is a mixed layer between an oleaginous solution and an aqueous solution as shown in Fig. 11, three inflection points appear on the curve of the output voltage shown at a right hand side of Fig. 11 and respectively correspond to the three boundaries of air-and-oleaginous solution, oleaginous solution-and-mixed layer, and mixed layer-and-aqueous solution. Thus, the output voltage characteristic allows detection of the boundaries.

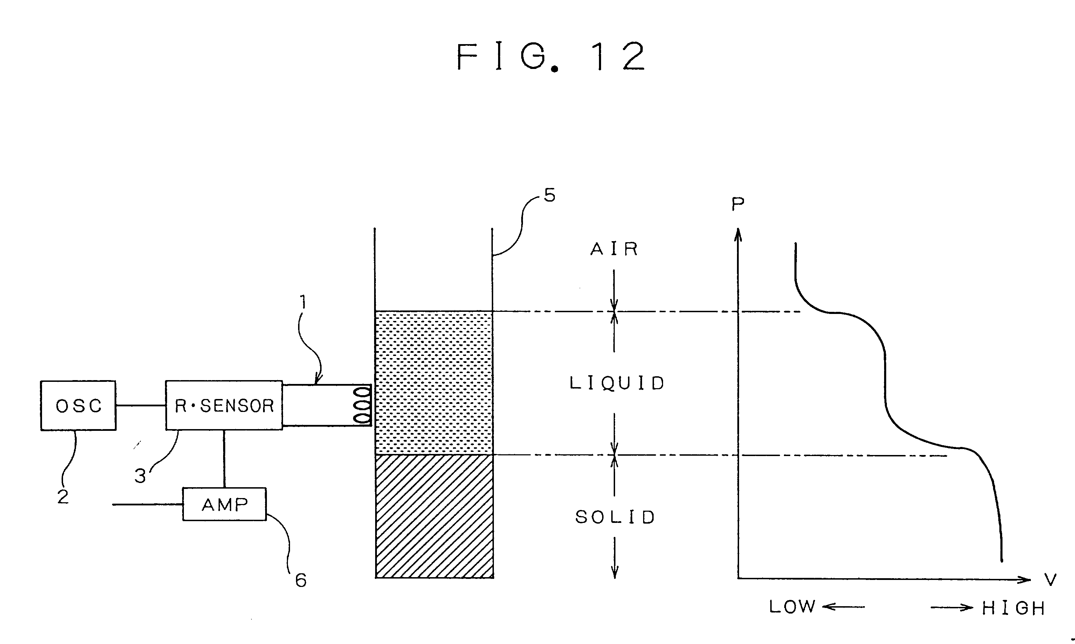

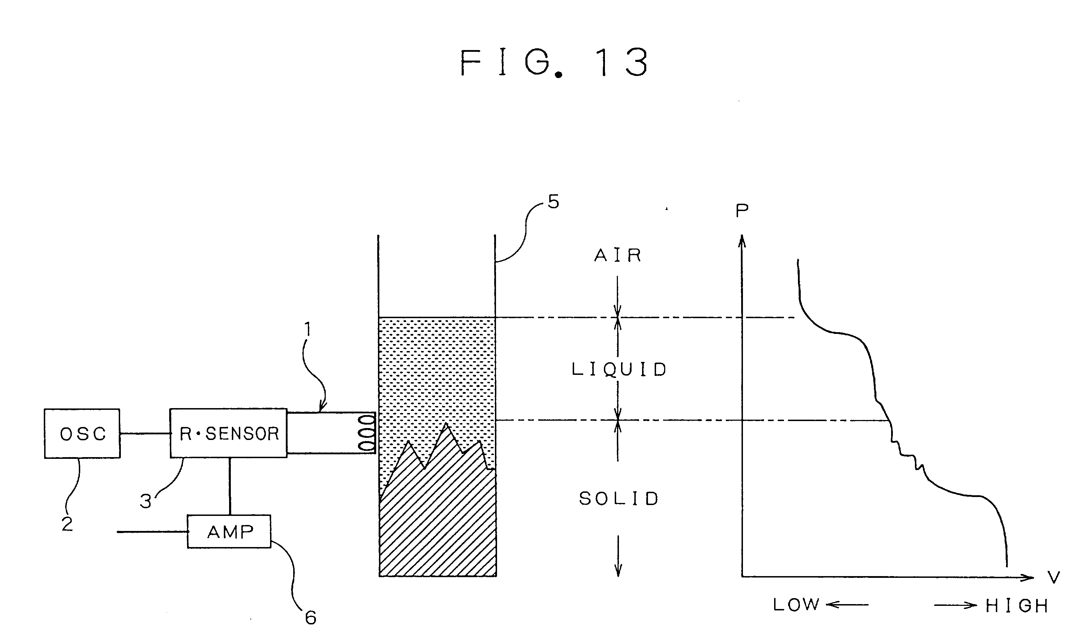

Figs. 12 and 13 show detection of liquid boundaries between liquid and solid. The boundary of Fig. 12 is horizontal and the boundary of Fig. 13 is deformed. In either cases, the liquid boundaries are detected by inflection points of an output voltage produced from the reflected wave sensor 3 through the amplifier 6.

Fig. 14 shows detection of a liquid level having bubbles. As the sensor 1 is lowered from top to bottom, an output voltage V provides a pair of inflection points in its output curve which correspond to the boundaries of air-and-bubbles and bubbles-and-liquid.

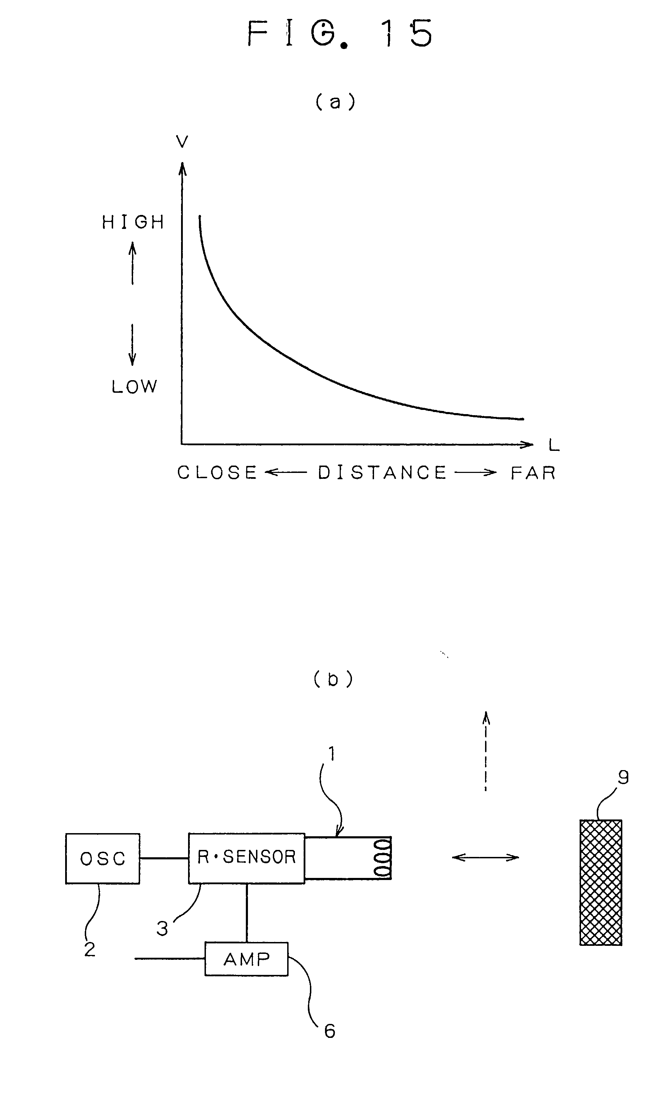

Figs. 15(a) and (b) show a detection of a distance L between the sensor 1 and a sample 9 to be measured. As the sample 9 approaches to the sensor 1 from a distant place as shown in Fig. 15(b), the output voltage V from the amplifier 6 rises as shown in Fig. 15(a). By proofreading a curve of a distance L and an output voltage V in advance, the distance between the sensor 1 and the sample 9 can be detected.

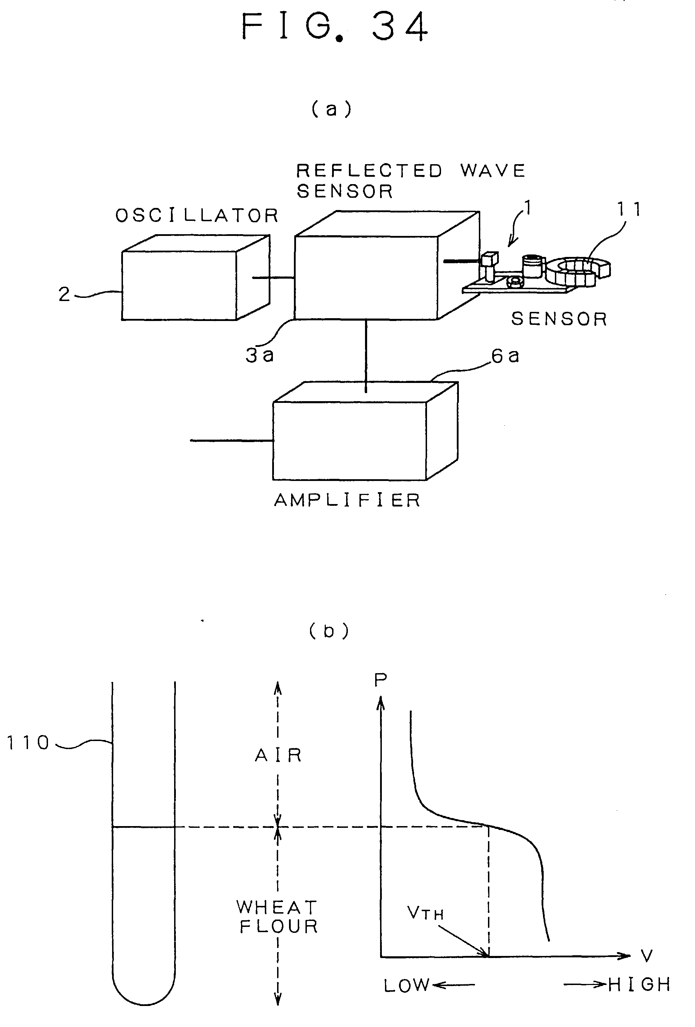

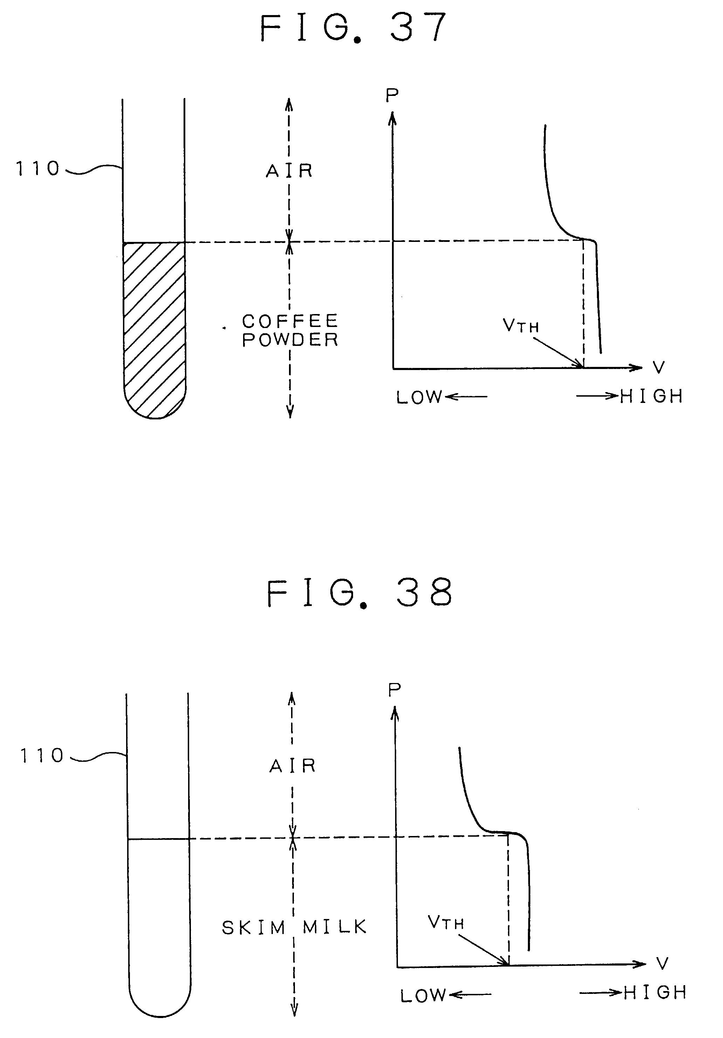

A mechanism for moving the sensor 1 up and down in Figs. 6 to 14 will be explained later in conjunction with Figs. 34 to 42.

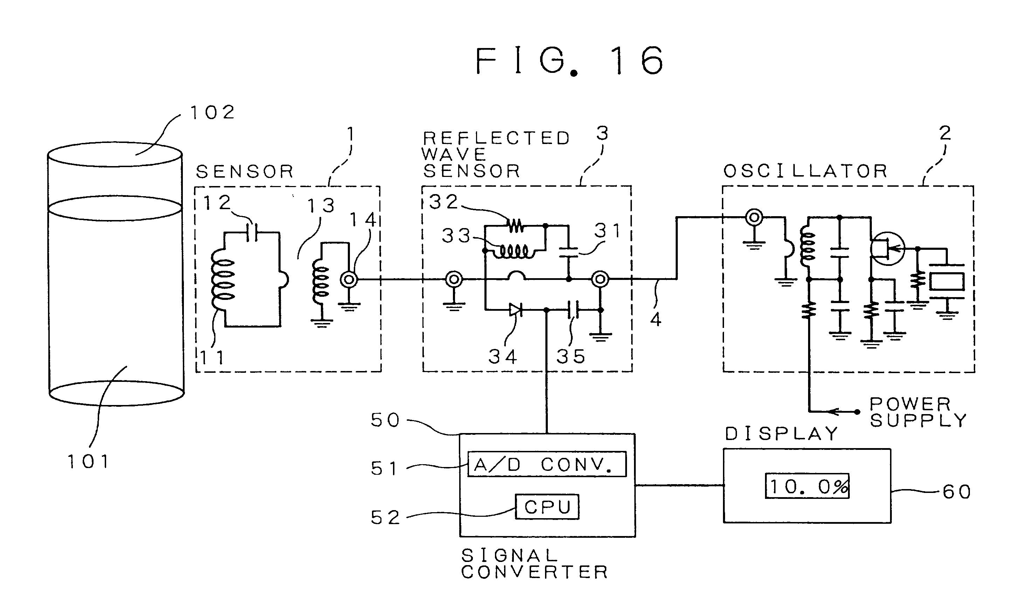

In Fig. 16 there is shown a circuit diagram of a liquid concentration sensing device as a second embodiment of this invention. The same components of Fig. 16 as those of the sensing device of Fig. 1 are represented by the same reference numerals. The concentration sensing device of this second embodiment includes sensor 1, oscillator 2 for transmitting a high frequency signal through transmission path 4 to the sensor 1, reflected wave sensor 3 as a detector detecting a reflection signal of the high frequency signal applied to the sensor 1 which is reflected by the sensor 1 and returning toward the oscillator 2, a signal converter 50 for converting the detected reflection signal into a concentration signal, and a display 60 for displaying the concentration. The signal converter 50 as a processor includes an A/D converter 51 and a CPU 52, and receives an analog signal from the reflected wave sensor 3 to be converted into a concentration signal (for example, "%") to be generated in a digital signal.

For measuring a concentration of a solution of salt by the liquid concentration sensing device, the sensor 1 is disposed near a container 102 containing a salt solution 101.

In the liquid concentration sensing device the oscillator 2 applies a high frequency signal to the sensor 1 through transmission path 4. Assuming that a resonance frequency of the resonance circuit is set to coincide with the frequency of the oscillator 2 and that an impedance of the sensor 1 and an impedance of the transmission path 4 are matched when a circumstance in the absence of a detected substance is air, the reflection of a transmitted high frequency signal is almost zero and the output from the reflected wave sensor 3 is zero. Since the container 102 of Fig. 6 contains the salt solution 101, the impedance of the sensor 1 is shifted from the matched impedance by a difference of magnetic permeability corresponding to the concentration of the solution 101, whereby a reflection signal having a level relating to the concentration of the solution of salt is generated. The reflection signal is converted into a concentration signal by the signal converter 50 to be displayed by the display 60.

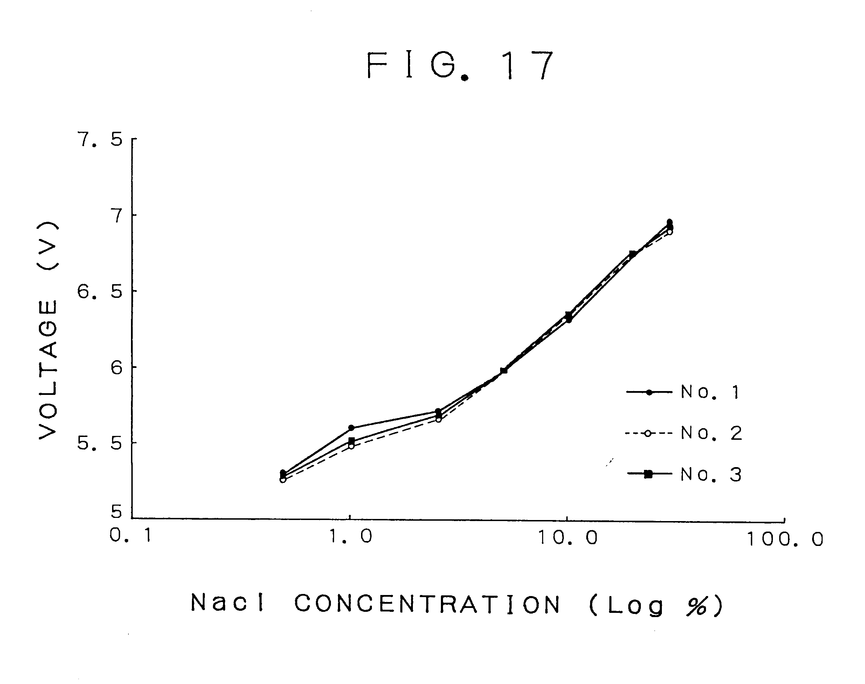

In Fig. 17 there is shown relation of a concentration of the salt solution measured by the liquid concentration sensing device and a detection voltage. The characteristic shown in Fig. 17 is previously stored in the signal converter 50, so that a concentration of salt solution (Log %) is detected from the detection voltage.

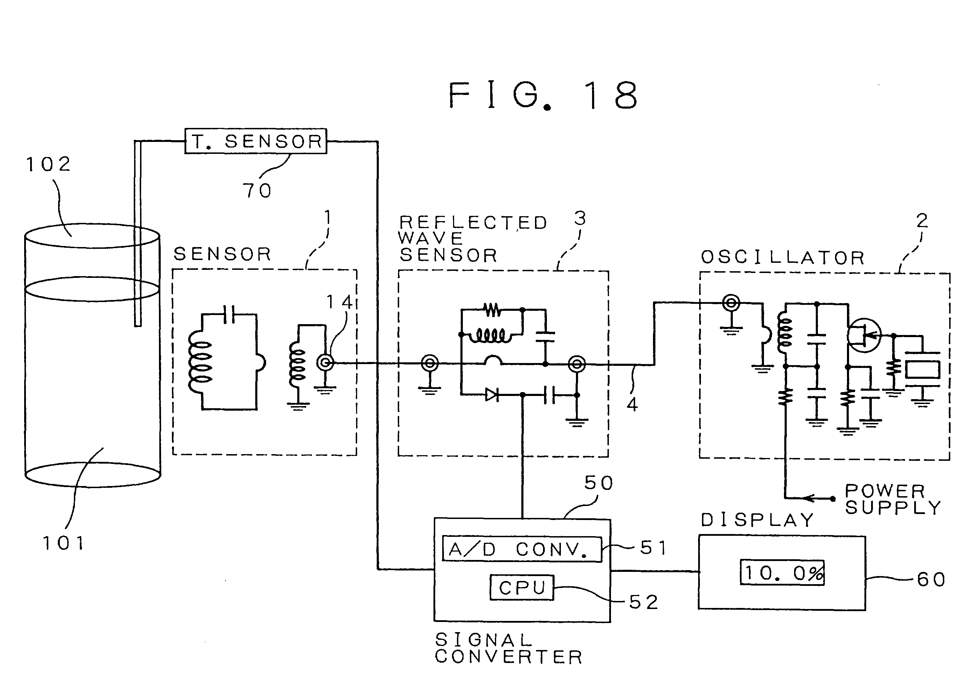

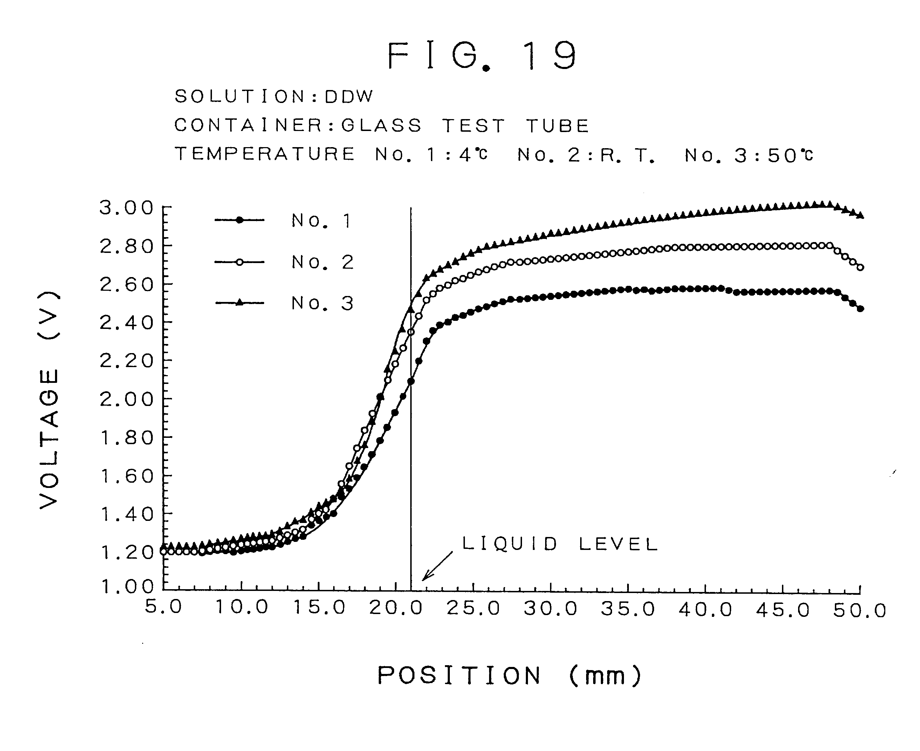

Fig. 18 shows a circuit diagram of a liquid concentration sensing device as a third embodiment of this invention. This sensing device further includes a temperature sensor 70 in addition to the circuit of Fig. 16. The temperature sensor 70 produces a temperature signal representing temperature of a solution of salt detected by the sensor 70 to be applied to the signal converter 50 to compensate the concentration signal with temperature. The permeability of solution of salt is subject to temperature and causes a measurement error due to ambient temperature. Accordingly the sensing device of this embodiment is provided with temperature compensation to improve the accuracy of the concentration detection. Fig. 19 is a graph showing results of measurement in the sensing device about an output voltage vs. a position of the sensor against a glass test tube container at the temperatures of 4°C, 25°C(room temperature) and 50°C.

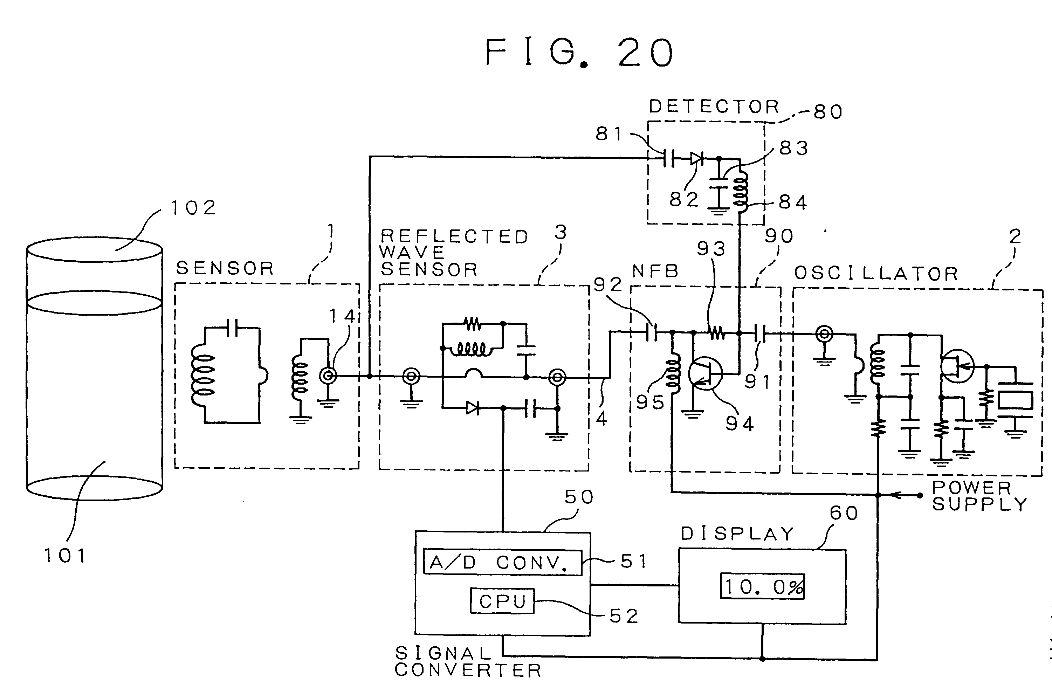

Fig. 20 shows a circuit diagram of a liquid concentration sensing device as a fourth embodiment of this invention. This sensing device further includes a detector 80 and a negative feedback circuit 90 in addition to the circuit of Fig. 16. The detector 80 includes a capacitor 81, a diode 82, a capacitor 83 and a coil 84. The capacitor 81 at one end thereof is connected with terminal 14 of the detector and at another end thereof is connected with an anode of the diode 82. A cathode of the diode 82 is grounded through the capacitor 83 and connected with one end of the coil 84. The negative feedback circuit 90 includes capacitors 91 and 92, a resistor 93, a transistor 94, and a coil 95. The capacitor 91, the resistor 93 and the capacitor 92 are connected in series and interposed between the oscillator 2 and the reflected wave sensor 3. A collector and a base of the transistor 94 are connected across the resistor 93, and a base of the transistor is connected with other end of the coil 84. The coil 95 is interposed between a power supply and the collector of the transistor 94.

When a faint signal like a concentration detection about a solution of salt is necessary to be processed, the stability of the detector is important. The temperature characteristic of components in use affects the accuracy of the detector, so that stabilization is important. For this purpose, an output signal is extracted from the detector 80 to be detected, and fed back by the negative feedback circuit 90 for stabilization of the output. The detector 80 converts the high frequency power supplied to the sensor 1 into a direct current signal. The negative feedback circuit 90 receives the signal from the detector 80. The circuit 90 decreases its amplification ratio when the received signal is high, but increases the ratio when the signal is low, whereby the power supplied to the sensor 1 is kept constant. The negative feedback circuit 90 may be replaced with an automatic gain control (AGC) circuit if desired. The transistor 94 also may be replaced with a FET or a PIN diode.

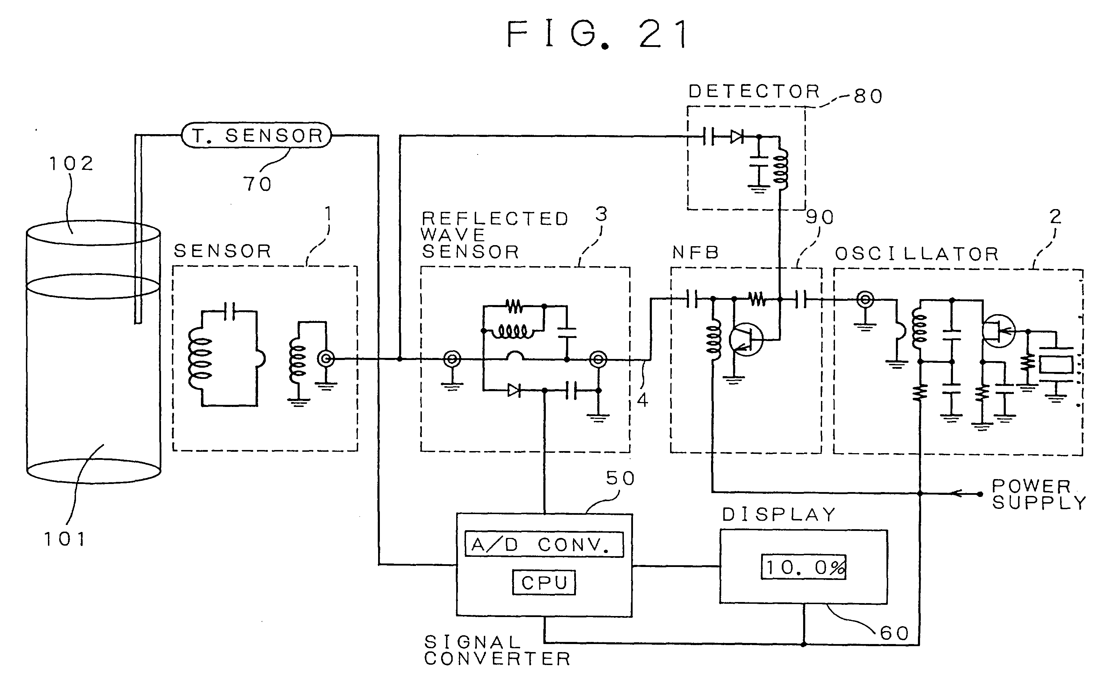

Fig. 21 shows a circuit diagram of a liquid concentration sensing device as a fifth embodiment of this invention. This sensing device further includes a temperature sensor 70, a detector 80 and a negative feedback circuit 90 in addition to the circuit of Fig. 16. This device provides a further improved stability in the variation of the output signal by temperature compensation and negative feedback.

A temperature measurement can be executed by utilizing the above-described relation of concentration and temperature. An aqueous solution having a temperature dependent concentration is employed, and relation between the concentration and temperatures is stored in a table of the sensing device. The concentration measured by the device is converted into a temperature by accessing the table to display the temperature for temperature measurement.

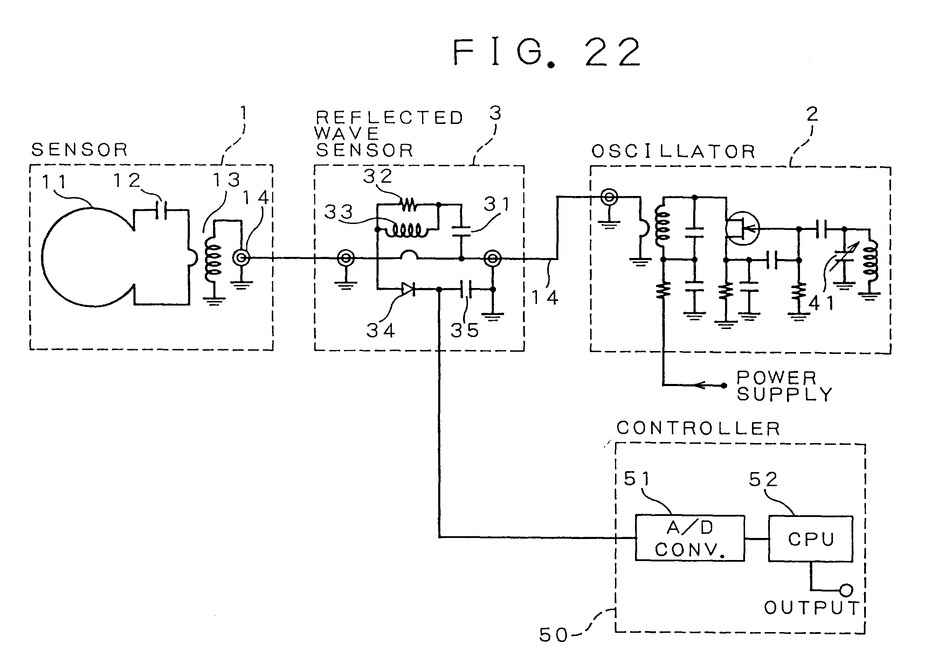

In Fig. 22 there is shown a circuit diagram of a human body sensing device as a sixth embodiment of this invention. The sensing device includes a sensor 1, an oscillator 2 transmitting a high frequency signal to the sensor 1 through a transmission path 4, a reflected wave sensor 3 for detecting a reflection signal which is reflected by the sensor 1 and returns toward the oscillator 2, a controller 50 for processing the detected reflection signal. The basic construction is the same as those of the above-mentioned sensing devices.

The sensor 1 includes a detection coil 11, a resonance capacitor 12 forming a series resonance circuit with the coil 11, and a real number transformer 13 in which a primary coil is connected with the resonance circuit and a secondary coil is connected with a high frequency input terminal 14 and an earth GND. The serial resonance circuit may be replaced with a parallel resonance circuit if desired.

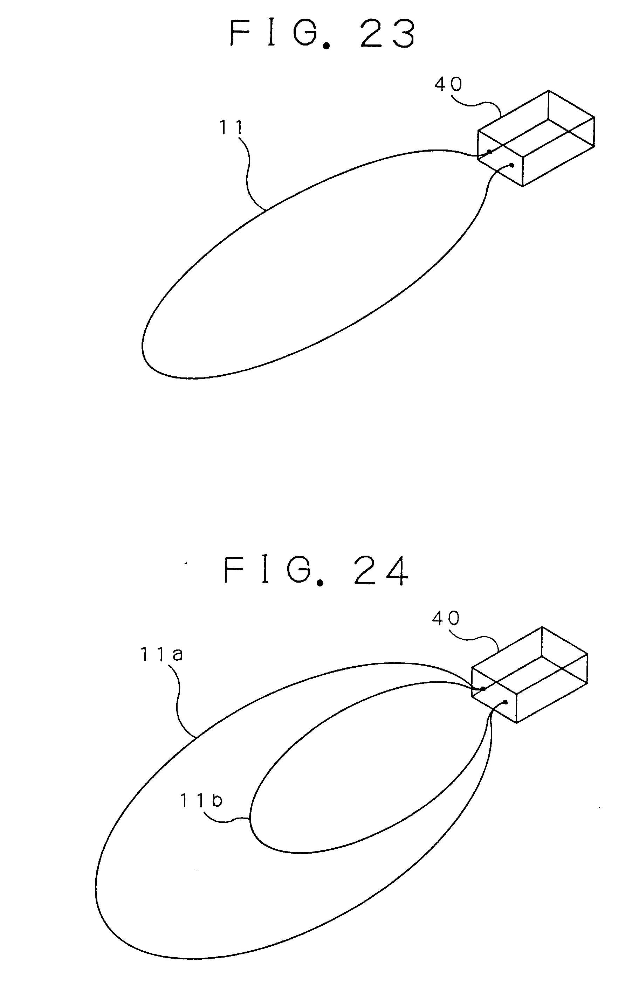

The detection coil 11 employs a circle one turn air-core coil having a diameter 200mm corresponding to a measured portion of the human body, the buttocks. The sensor 1 other than the coil 11, the oscillator 2, the reflected wave sensor 3 and the controller 50 are housed within a housing 40. If desired, the detection coil 11 may be modified to have a coil 11a having a diameter 200mm and a coil 11b having a diameter 100mm which are selectively used or connected in series as shown in Fig. 24.

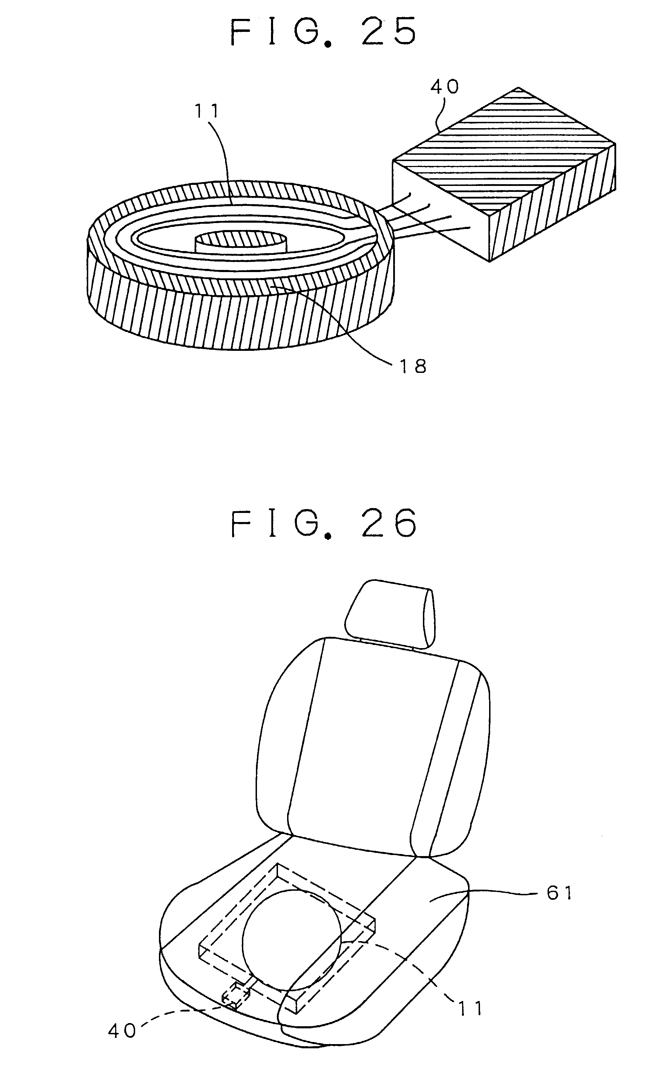

As shown in Fig. 25 as a further modification of the detection coil, the detection coil 11 may be wound around a magnetic core 18 having an E-shaped section so that a magnetic field can be generated only in one direction lying at right angles to a wall of the coil 11. If desired, number of turns and a diameter of the coil 11 may be changed in accordance with the object to be detected. The conductive wires of the detection coil 11 employs a good conductive metal about a high frequency signal such as Au(gold), Ag(silver), Cu(copper), Al(aluminum) and so forth. By constructing the detection coil 11 with such good conductive metal the sensitivity is improved and a high frequency power loss is reduced.

The oscillator 2 employs a LC resonance type oscillator. The oscillation circuit itself may be other conventional high frequency oscillation circuit such as a crystal oscillator or PLL. The oscillator 2 employs a variable capacitor 41. By automatically changing the capacity of the capacitor 41 the frequency of the high frequency signal generated from the oscillator 2 is scanned, for instance, between 30 MHz and 50 MHz. A scanning mechanism may be provided in the oscillator itself, or the frequency may be changed according to an instruction generated from the controller 50.

The reflected wave sensor 3 is the same component as those of Figs. 1 and 16. The controller 50 includes an A/D converter 51 and a CPU 52, and converts an analog signal from the reflected wave sensor 3 into a digital signal for a logical process in view of the reflection level and frequency to execute a judgement detecting process for vacancy, baggage or seating of the human body.

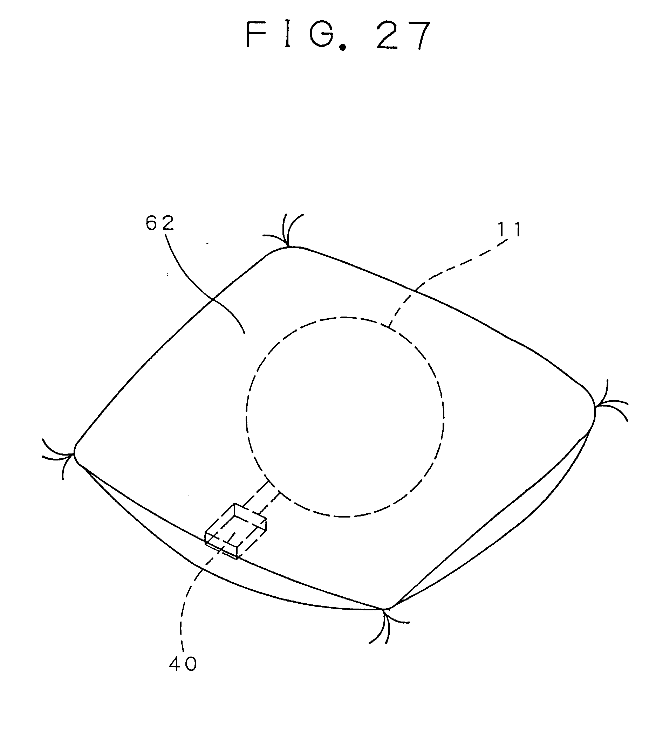

The human body sensing device of this embodiment is buried within a bottom of a seat (in an automobile, a train, a theater and so forth) 61 as shown in Fig. 26 or within a seat cushion 62 as shown in Fig. 27. The device may be buried within other portions of a seat such as a support for the back of the seat.

The oscillator 2 generates a high frequency signal to be applied to the sensor 1 through the transmission path 4. The high frequency signal of the oscillator 2 is scanned between 30 MHz and 50 MHz. The high frequency signal supplied to the sensor 1 is reflected by the sensor 1. The impedance of the sensor 1 varies with a substance positioned near the detection coil 11 due to the difference of magnetic permeability of the substance to change the level of the reflected wave produced by external circumstance near the detection coil. The reflected wave is detected by the reflected wave detector 3, and the controller 50 detects vacancy, baggage or the human body in view of the reflection level and frequency.

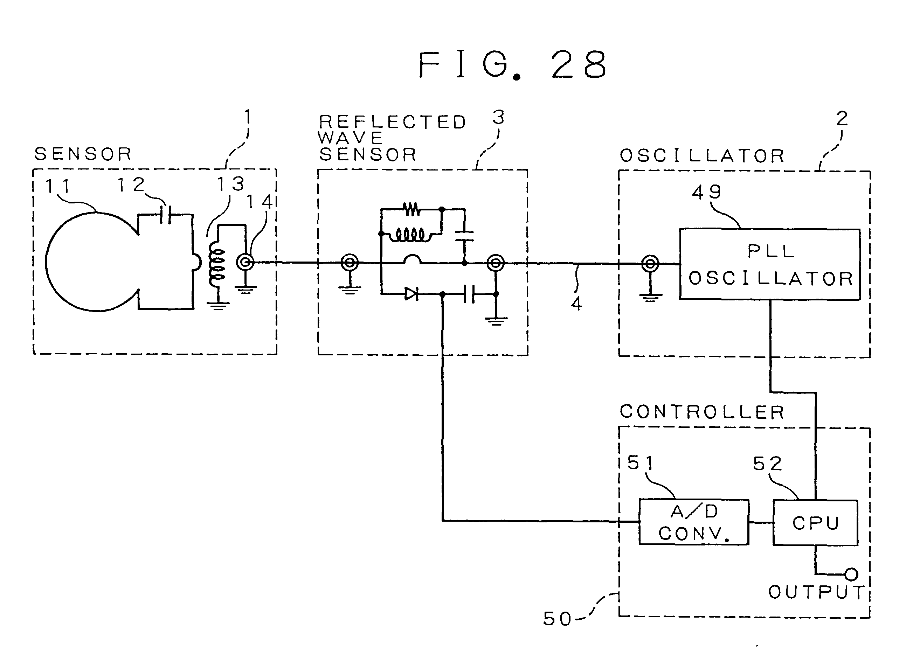

Fig. 28 shows a circuit diagram of a human body sensing device as a seventh embodiment of this invention, in which a sensor 1 and a reflected wave sensor 3 are same as those of Fig. 22. An oscillator 2 employs a PLL oscillator 49 different from the oscillator 2 of Fig. 22, and changes the high frequency according to an instruction from the CPU 52 of the controller 50.

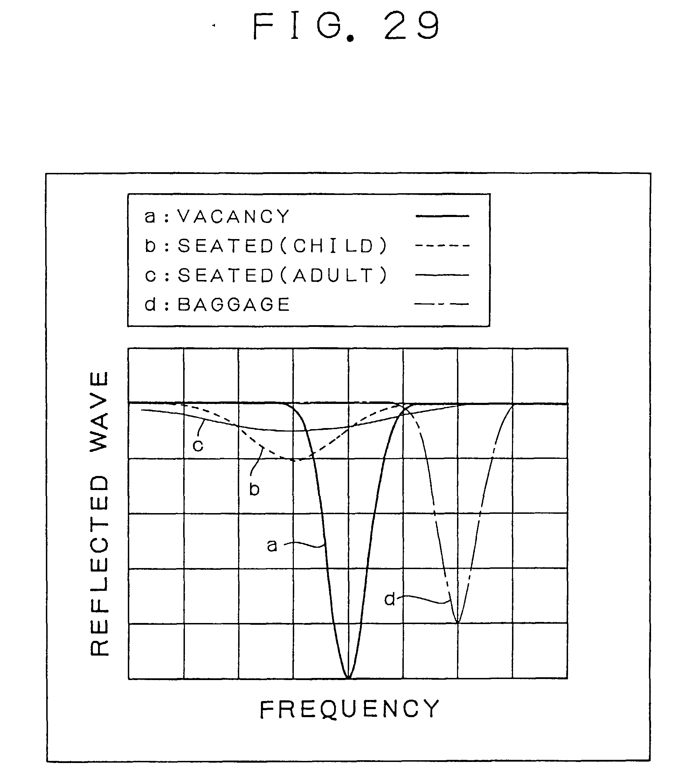

As the human body sensing device of Fig. 28 is installed into the seat 61 of Fig. 26 or the cushion 62 of Fig. 27 and the oscillator 2 is activated, the characteristic of the reflected wave when the seat is vacancy, seated by a child, seated by an adult and put by baggage is shown by curves "a", "b", "c" and "d" of Fig. 29. In the curve "a" of vacancy and the curve "d" of baggage, the reflected wave is very small at a frequency and the quality factor "Q" is high. In the curves "b" and "c" of seating of the human body, the reflected wave becomes small at a frequency but a degree of the variation of the reflected wave is small and the factor Q is small. Such difference of the frequency characteristic of the reflected wave is made by difference of permeability of vacancy (air), baggage and the human body.

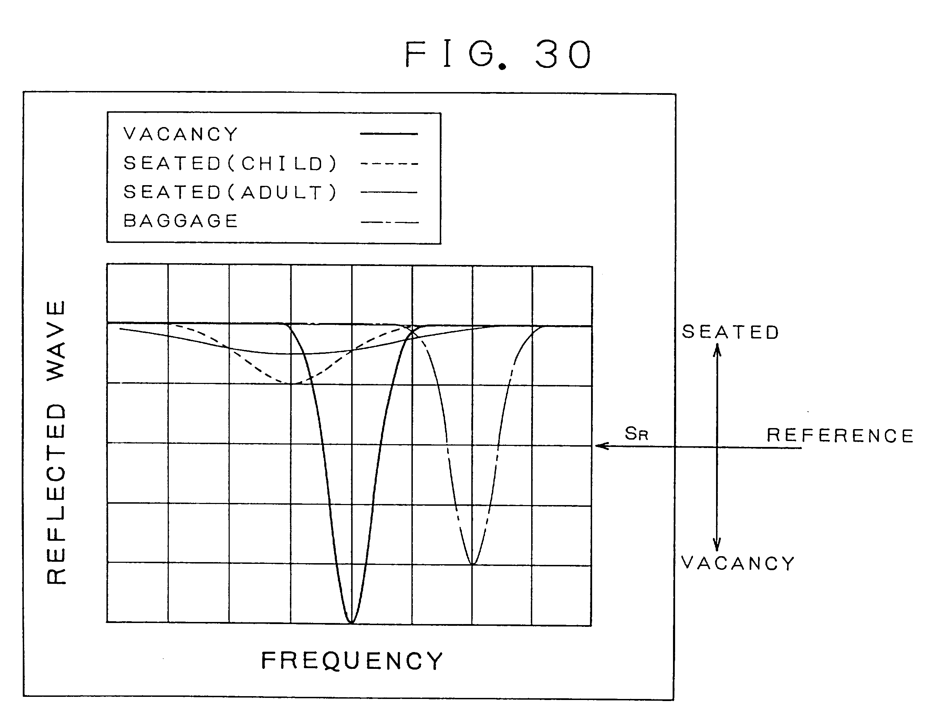

Fig. 30 includes the graph of Fig. 29 and a reference indication. If the level of the reflected wave detected by the reflected wave sensor 3 is larger than a reference value S_{R} over a whole frequency range as shown in Fig. 30, it means that the human body is seated. If there is a frequency where the level of a reflected wave is lower than the reference value S_{R}, it means that the seat is vacancy or put by baggage. The CPU 52 of the controller 50 judges the human body, vacancy and baggage. The same judgement is executed in the human body sensing device of Fig. 22 as well.

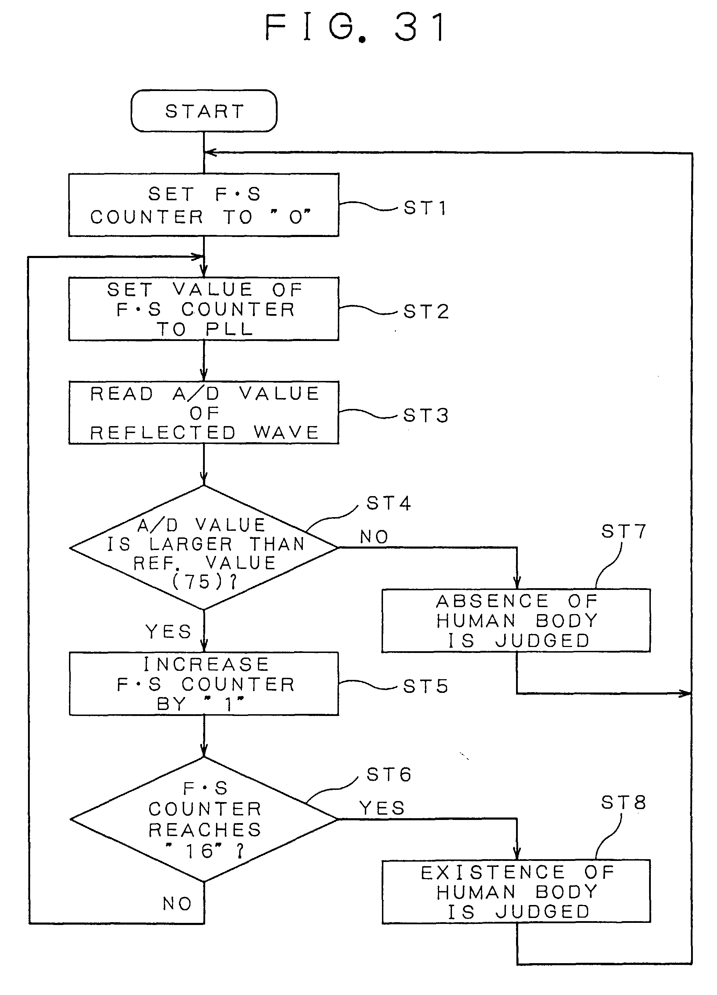

A detection operation by the human body sensing device of Fig. 28 will be described hereinafter in conjunction with a flow chart of Fig. 31.

In the CPU 52 a frequency setting counter is set to "0" (step ST1). Then a count value of the frequency setting counter is set to the PLL oscillator 49 of the oscillator 2 (step ST2). In this sate the oscillator 2 oscillates a high frequency signal of a frequency corresponding to the set value. The high frequency signal is applied to the sensor 1 through the transmission path 4, and a reflection signal according to an external state is detected by the reflected wave sensor 3. The CPU 52 reads the A/D converted value of the reflection wave through the A/D converter 51 (step ST3).

It is inquired if the read A/D value of the reflected wave is a reference value (75) or larger (step ST4). If the read A/D value is the reference value or larger, the frequency setting counter is increased by "1" (step ST5) and it is inquired whether or not the counted value of the frequency setting counter reaches "16" (step ST6). At first the counted value does not reach "16" and the sequence returns to the step ST2 where the counted value of the frequency setting counter increased by "1" is set to the PLL oscillator 49 and the oscillator 2 oscillates at a frequency corresponding to the new counted value. The sequence from the step ST2 to the step ST6 is repeated likewise.

If the A/D value is smaller than the reference value (75) before the counted value of the frequency setting counter becomes 16, a NO response is generated at the step ST4. As shown in Fig. 30 this means that the level of the reflected value is smaller than the reference value S_{R} at a frequency and the factor Q is high. Accordingly it is judged that the seat is vacancy or put by baggage and that there is not the human body (step ST7). As the counted value of the frequency setting counter becomes "16", one time scanning of frequency change is completed. Unless there is any reflected wave having an A/D value smaller than the reference value at this time point, this means in Fig. 30 that the level of the reflected wave is the reference value S_{R} or larger over the scanning frequency range. Accordingly, as the counted value of the frequency setting counter becomes "16" at the step ST6, an YES response is generated and the presence of the human body is judged (step ST8).

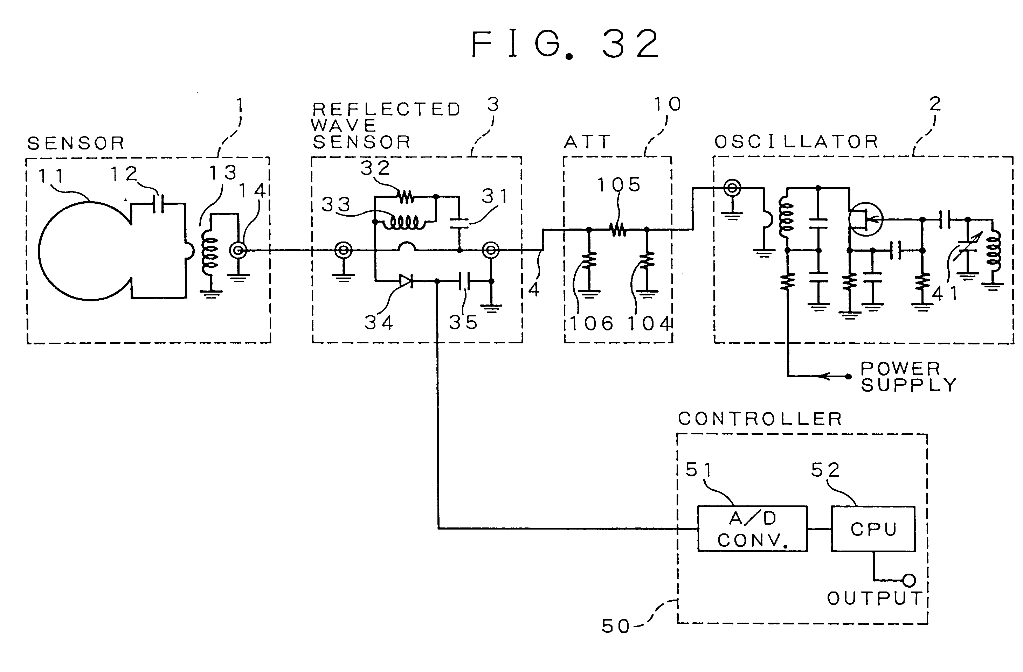

Fig. 32 shows a circuit diagram of a human body sensing device as an eighth embodiment of this invention, which includes an attenuator 10 additionally interposed between the oscillator 2 and the reflected wave sensor 3 of Fig. 22. The attenuator 10 employs a π type circuit consisting of resistors 104, 105 and 106, but may employ other type circuit.

As the impedance of the sensor 1 largely varies with a substance to be measured, the signal from the sensor 3 increases. In this time point the load impedance of the oscillator 2 and the input impedance of the sensor 1 are not matched and the operation of the oscillator 2 is unstable. To prevent this unstable operation, the attenuator 10 is disposed at an output side of the oscillator 2 and a part (preferably about 50%) of the output of the oscillator 2 is always consumed by the resistors. Even if the impedance largely varies and matching is not obtained, the oscillator 2 safely operates by stabilizing the load impedance of the oscillator 2. The attenuator 10 may be disposed into the circuit of Figs. 1, 16, 18, 20, 21, 22, and 28.

Though the level of the reflected wave is detected by the reflected wave sensor 3 in the above-mentioned embodiments, a standing-wave ratio (SWR) may be measured as described later.

As a modification of the foregoing embodiments, the sensing device may be so designed that the high frequency signal generated from the oscillator is applied to the sensor through the transmission path and a phase shift against the high frequency signal transmitted in the detector from the transmission path. As other modification of the foregoing embodiments, the sensing device may be so designed that the high frequency signal generated in the oscillator is supplied to the sensor including a resonance circuit through a transmission path and a voltage or a current in the sensor is detected according to the external status such as vacancy, baggage, the human body or the like to detect a substance. The human body sensing devices of the foregoing embodiments are designed to identify vacancy, baggage and the human body as a human body sensor, but may be applied to a substance sensor for sensing substances other than baggage.

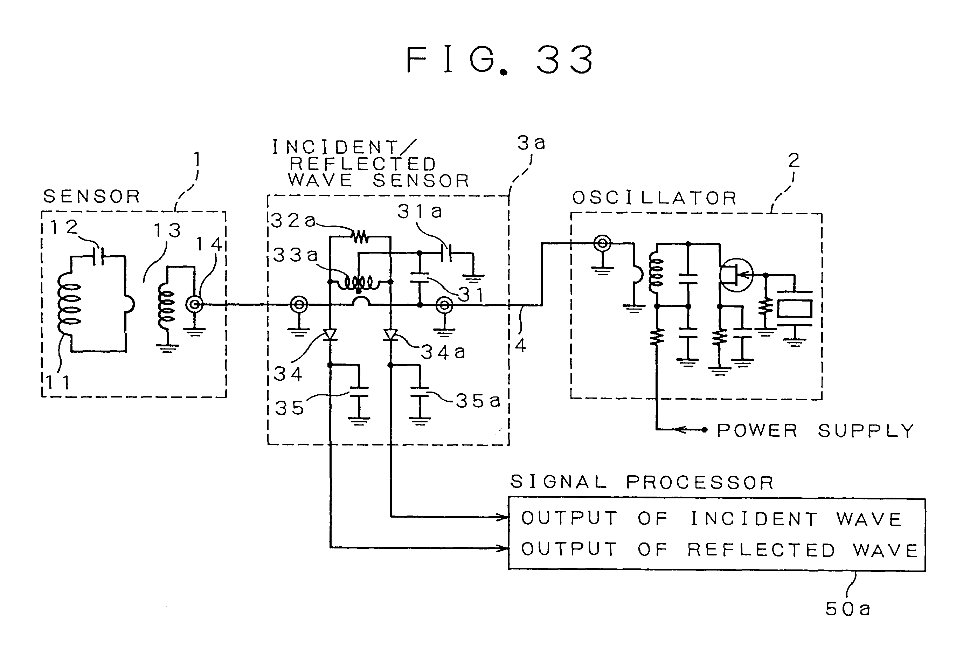

In Fig. 33 there is shown a circuit diagram of a powder sensing device as a ninth embodiment of this invention, which includes an oscillator 2 oscillating a high frequency signal, a sensor 1, a transmission path 4, an incident/reflected wave sensor 3a, and a signal processor 50a. The sensor 1 and the oscillator 2 employ the same components as those of Fig. 1. Though the reflected wave sensor 3 of Fig. 1 is designed to sense a reflected wave, the incident/reflected wave sensor 3a of this embodiment is designed to sense a level of an incident wave applied to the sensor 1 through the transmission path 4.

In the incident/reflected wave sensor 3a, a capacitor 31 at one end thereof is connected with the transmission path 4 and at other end thereof is grounded through a capacitor 31a and connected with the middle of a coupling coil 33a. The coupling coil 33a is connected with a resistor 32a in parallel, one end of the parallel circuit is connected with an anode of a diode 34, and a cathode of the diode 34 is grounded through a capacitor 35a. A reflected wave signal and an incident wave signal are generated through diodes 34 and 34a.

The generated incident wave signal and reflected wave signal are computed to produce the standing-wave ratio of the two signals in the signal processor 50a. The presence or absence of powder near the sensor 1 is detected based on the ratio. If the impedance of the sensor 1 and the impedance of the transmission path 4 are matched when there is no powder, the presence of powder changes the impedance of the sensor 1 due to the change of permeability of the powder and makes the matching disappear so that the high frequency signal sent to the transmission path 4 is reflected. The sensing device of this embodiment employs a ratio between the incident wave and the reflected wave, whereby stable detection is performed without worrying output variation in the oscillator 2. The signal processor 50a computing the ratio of the incident and reflected waves may employ the A/D converter and the CPU of Fig. 16 or an analog arithmetic circuit generating an output relating to the ratio.

Fig. 34 shows an example of the powder sensing device of this embodiment sensing wheat flour. As the detection coil 11 of the sensor 1 is moved up and down near a container 110 containing wheat flour, the detection voltage V (ratio) is high in a region of the wheat flour and low in the region of air. Accordingly, if a threshold value V_{TH} is set, the region where the output is larger than the threshold value V_{TH} can be regarded as the region in the presence of wheat flour.

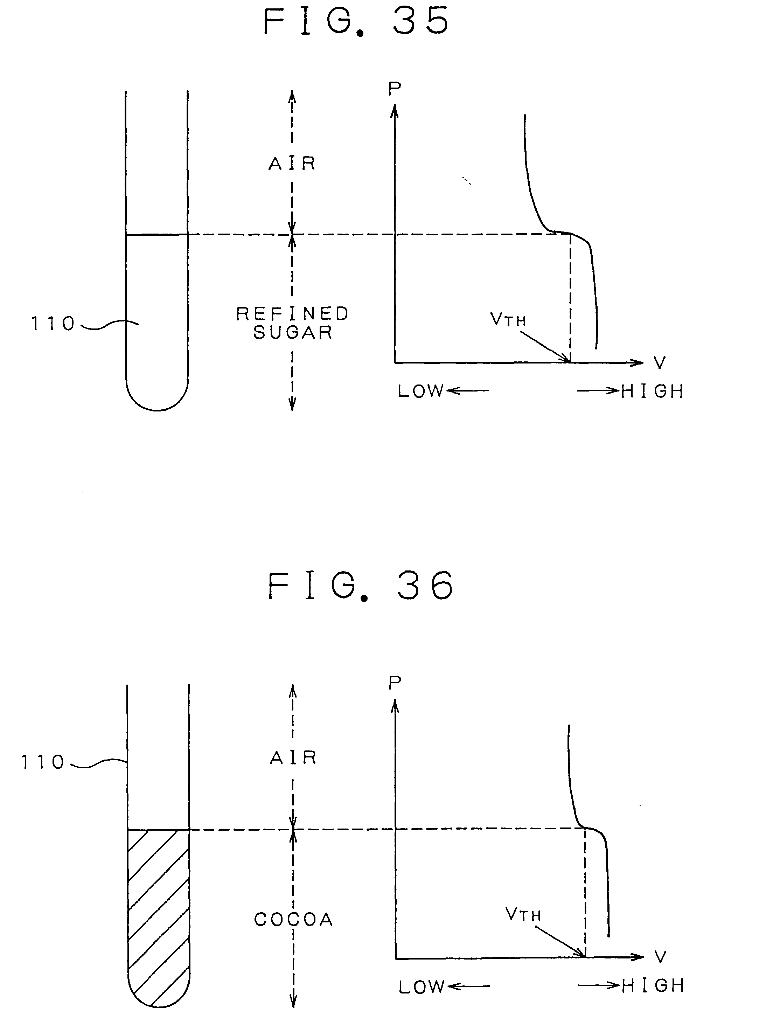

Figs 35 to 38 show relation between the position P of the sensor 1 of the sensing device of Fig. 33 and an output voltage V of the device when refined sugar, cocoa, coffee powder and skim milk are respectively contained into a container 100 and the detection coil 11 is moved up and down along the container 110 like Fig. 34. The boundary output voltages in regions of air and powder are different and there exists step therebetween, so that a powder level within the container can be detected by setting a threshold value V_{TH} near a boundary output. The respective boundary values are different, so that unknown powder within the container can be identified about the kind by introducing a characteristic of the difference.

The sensing device of this embodiment is described as a sensor sensing powder, but the circuit device computing a ratio of an incident wave to a reflected wave is applicable to a sensor sensing other material such as liquid and so forth.

Humidity can be measured by employing hygroscopicity powder. The relation of humidity and reflected wave output is measured and the measured relation is stored in a table in advance. The sensing device of this embodiment measures a output of a reflected wave, and converts the output into humidity in view of the table to be displayed. Thus a humidity measurement device is provided.

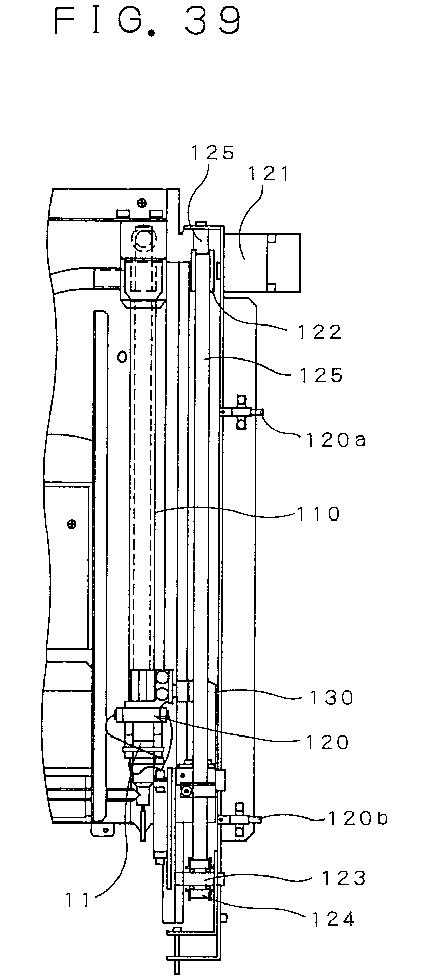

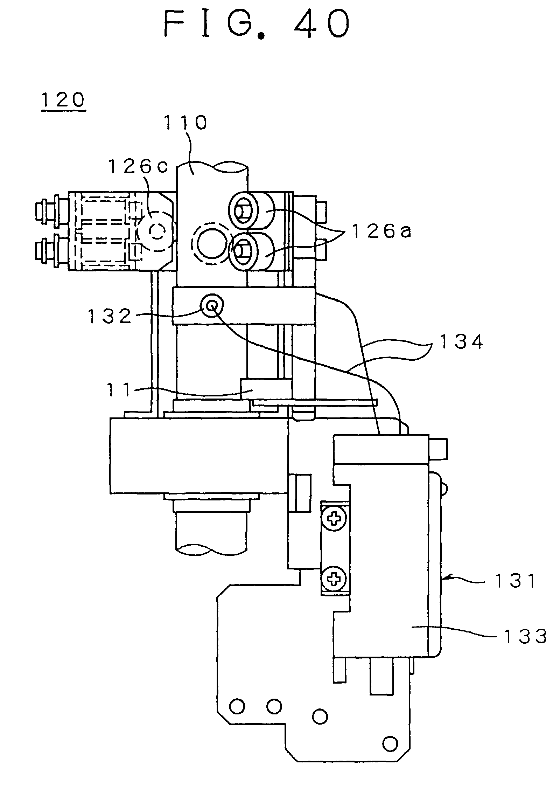

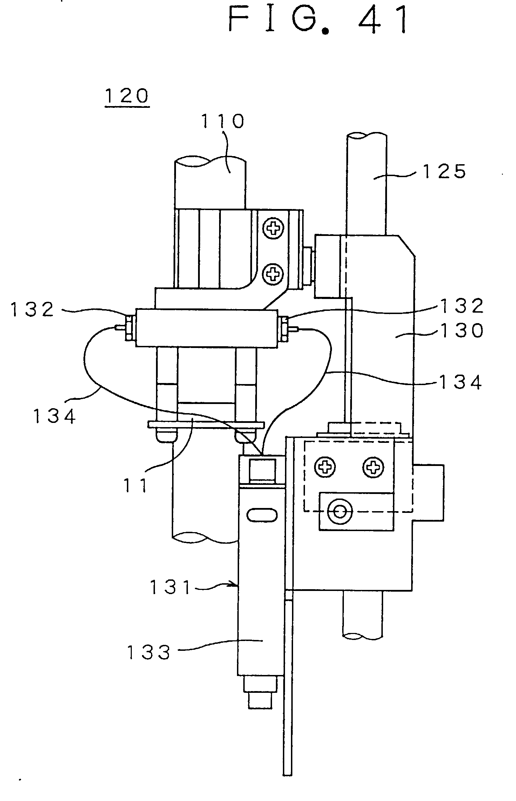

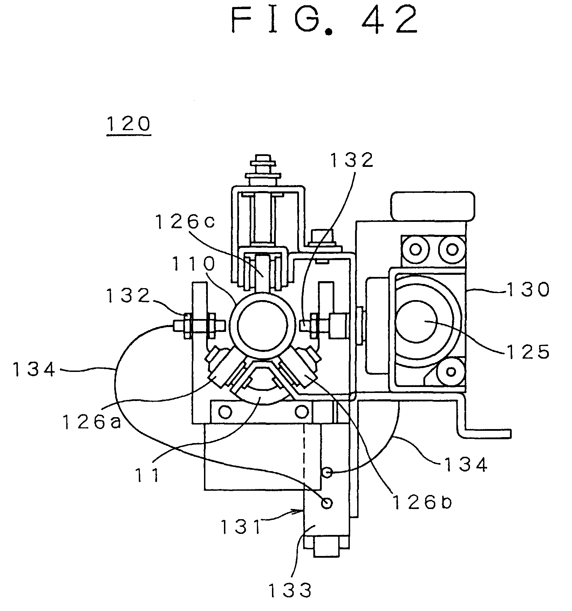

An example of a mechanism for moving up and down the detection coil 11 of Fig. 34 or the sensor 1 shown in Figs. 6 to 14 near the container is shown in Figs. 39 to 42. Fig. 39 shows a side view of a mechanism moving up and down a sensor 120 along a tube (container) 110 having a small diameter. Fig. 40 is an enlarged side view of the sensor 120 viewed in a view direction. Fig. 41 is an enlarged side view of the sensor 120 viewed in an other view direction, and Fig. 42 is an enlarged plane view of the sensor 120 viewed from the top.

In Figs. 39 to 42, the sensor 120 is supported by a support member 130 for a up and down movement. The support member 130 is fixed by a belt 125 engaged between a pulley 122 mounted on a rotary shaft of a pulse motor 121 and a pulley 124 rotatably mounted on a shaft 123 by a bearing, and guided by a guide shaft 125 standing along the narrow tube 120. As a moving member for the sensor 120, a combination of a pole screw and a nut or a linear pulse motor may be employed instead of the above-mentioned belt and pulley. There are disposed at a predetermined position an upper limit detector 120a for detecting an upper limit position of the sensor and a lower limit detector 120b for detecting a lower limit position of the sensor.

The sensor 120 is constituted with the sensor 1 of the detector of Fig. 33 and a photo sensor 131. The photo sensor 131 includes a light projecting and receiving member 132 sandwitching the narrow tube 110 in a confronting relationship, and an optical fiber 134 connected with a photo sensor body 133 enclosing a light emitting element and a light receiving element. The photo sensor 131 is not directly related to this invention. The detection coil 11 of this invention is disposed at a slight lower position than the light projecting and receiving member 132 of the photo sensor 131, and the detection coil 11 is near a peripheral surface of the narrow tube 110.

The sensor 120 is located from the narrow tube 110 for a distance by rollers 126a, 126b and 126c contacting the tube 110 in three directions. A pair of rollers 126a and 126b are arranged in a vertical line. As the pulse motor 121 is turned on, the sensor 120 is moved up or down along a guide shaft 125 above or under the support member 130. The sensor 120 moves together with a support member 130, and the light projecting and receiving member 132 of the photo sensor 131 and the detection coil 11 of the sensor 1 stably move retaining a predetermined distance from and near the narrow tube 110.

According to this invention, substance, material and the human body is sensed by detecting a signal relating to change of permeability near a sensor, whereby the detection of a substance contained in a stained or opaque container which cannot be sensed by a photo sensor can be performed. Even if a container is adhered by a label, a substance within the container can be sensed. The detection of a material of a substance which cannot be detected by a photo sensor, an electric conductive method and an ultrasonic sensor is performed based on a difference of magnetic permeability of the substance. Contactless detection is also possible. The detection of a boundary face of different material which cannot be detected by an electric conductive method, an ultrasonic, a dielectric method, and a proximity switch can be performed. Any reflector nor a pair of electrodes are not necessary. Any float also is not necessary in the detection of a liquid level. The liquid level detection is not influenced by bubbles. A substance and liquid within a closed container can be detected. The sensing device of this invention can be used as a proximity switch sensing a material other than metals. A distance between a substance and liquid also can be measured. These effects can be selectively found in the foregoing sensing devices capable detecting articles to be detected.

While the invention has been described and illustrated with respect to certain embodiments which give satisfactory results, it will be understood by those skilled in the art, after understanding the purpose of the invention, that various other changes and modifications may be made without departing from the scope of the invention, and it is, therefore, intended in the appended claims to cover all such changes and modifications.

## Claims

1. A sensing device comprising
an oscillator (2) for generating a high frequency signal,
a sensor (1) including a resonance circuit receiving said high frequency signal from the oscillator (2), and
a detector (3) for producing a signal relating to a variation of an impedance change of said sensor (1),
characterized in that
said sensor (1) and said detector (3) consist of passive elements without employing any active elements.

2. A sensing device according to claim 1, in which said resonance circuit includes a coil (11) wound around a toroidal core (15).

3. A sensing device according to claim 1, in which said sensor (1) further includes a transformer (13) for supplying said resonance circuit with power and said resonance circuit includes a detection coil (11) for sensing a state near the detection coil (11) and a capacitor (12) connected in series or parallel with the detection coil (11).

4. A sensing device according to claim 1, said high frequency signal is designed to be such a high frequency that there exists a difference in outputs of said detector (3) in the presence and the absence of a predetermined non-magnetic material or substance near said sensor (1).

5. A sensing device according to claim 4, in which said frequency is between 10 MHz and 300 MHz.

6. A sensing device according to claim 1, in which said resonance circuit is disposed to be influenced by the magnetic permeability of a material or substance nearby, and said detector (3) detects a variation of said resonance circuit influenced by the magnetic permeability of the external near material or substance.

7. A sensing device according to claim 1, in which said resonance circuit has such a resonance frequency that a signal frequency of said oscillator (2) is positioned on a steep slope of a resonance characteristic, and the signal produced by said detector (3) relates to an external state near said sensor (1).

8. A sensing device according to claim 1, in which said resonance circuit resonates and the imaginary number of said impedance is set to be around zero when an external neighbor state is reference state, and the signal produced by said detector (3) relates to an increase of the imaginary number of said impedance of the sensor (3).

9. A sensing device according to claim 1, in which said detector (3) is adapted to detect a reflected wave reflected in accordance with an external state near said sensor, and the signal produced by said detector (3) relates to said reflected wave.

10. A sensing device according to claim 9, in which said detector (3) is adapted to detect a phase shift of said reflected wave against said high frequency signal produced by said oscillator (2).

11. A sensing device according to claim 9, in which said detector (3) is adapted to convert power of said reflected wave into a voltage to generate the converted voltage.

12. A sensing device according to claim 1, in which said detector (3) is connected with said oscillator (2) and said sensor (1) for separating an incident wave from said oscillator (2) and a reflected wave from the sensor (1) to respectively produce signals respectively corresponding thereto.

13. A sensing device according to claim 12, further comprising
a processor (50a) connected with a pair of outputs of said detector (3a) for producing an output signal relating to a ratio between said incident wave from said oscillator (2) and said reflected wave from said sensor (1).

14. A sensing device according to claim 1, further comprising
an attenuator (10) employing a resistor (105) interposed between said detector (3) and said oscillator (2).

15. A sensing device according to claim 14, in which said attenuator (10) is designed to consume 50% of an output from said oscillator (2).

16. A sensing device according to claim 1, further comprising
a negative feedback circuit (90) interposed between said sensor (3) and said oscillator (2).

17. A sensing device according to claim 1, further comprising
judging means (52) for discriminating said output signal of said sensor (1) to judge the presence or absence of a predetermined liquid.

18. A sensing device according to claim 1, further comprising
a boundary detector (50) for detecting a changing point of a reflection signal from said sensor (1) based on said signal from said detector (3) to detect a boundary of a substance.

19. A sensing device according to claim 1, further comprising
a powder detector (50a) for discriminating said output signal from said sensor (1) at a level to judge the presence or absence of a powder.

20. A sensing device according to claim 1, in which said detector (3) is adapted to detect a hygroscopicity powder disposed near said sensor and a reflected wave of said sensor (2) to generate a signal relating to said reflected wave, said sensing device further comprising
a processor (50 and 50a) for converting said output signal of said detector into humidity.

21. A sensing device according to claim 1, further comprising
a processor (50) for converting said output signal from said detector into a solute concentration, and
a display (60) for displaying the output signal from said processor.

22. A sensing device according to claim 21 further comprising
a temperature sensor (70) for sensing temperature of liquid, in which said processor (50) compensates said concentration about temperature based on an output from said temperature sensor (70).

23. A sensing device according to claim 1, in which said detector (3) is adapted to detect a reflected wave reflected from a temperature dependent water solution disposed near said sensor (1) to produce a signal relating to said reflected wave, said sensing device further comprising
a processor (50) for converting said output signal relating to said temperature of said water solution into temperature, and
a display (60) for displaying an output signal produced from said processor (50).

24. A sensing device according to claim 1, further comprising:
a controller (50) for detecting a substance based on an output signal produced from said detector (3) and said oscillation frequency generated from said oscillator (2).

25. A substance sensing device according to claim 24, in which a coil (11) of said resonance circuit is an air-core coil having at least one turn.

26. A substance sensing device according to claim 24, in which a coil (11) of said resonance circuit is wound around a magnetic member (18).

27. A substance sensing device according to claim 24, in which said resonance circuit includes a plurality of coils (11a and 11b).

28. A sensing device according to claim 1, further comprising
a controller (50) for identifying said human body and other substances for detection based on an output signal produced from said detector (3) and said oscillation frequency generated from said oscillator (2).

29. A sensing device according to claim 28, in which said resonance circuit comprises a coil (11) installed within a seat (61).

30. A sensor according to claim 28, in which said resonance circuit comprises a coil (11) installed within a cushion (62).

31. A substance sensor according to claim 28, 29 or 30, in which said coil (11) is made of a material of good conductivity about a high frequency signal.

32. A sensing device according to claim 1, in which said sensor (1) has a coil (11) so disposed to be influenced by said permeability of a material or substance near said sensor, said sensing device further comprising
a detector (3) for detecting a variation in said resonance circuit influenced by a permeability of a material or substance externally existing near said sensor (1) to produce a signal relating to said variation,
said sensor (1) being connected with said oscillator (2) and said detector (3) through a cable and separately isolated from said oscillator (2) and said detector (3).

## Patentansprüche

1. Sensorvorrichtung mit
einem Oszillator (2) zur Erzeugung eines Hochfrequenzsignals,
einem Sensor (1), welcher einen das Hochfrequenzsignal vom Oszillator (2) erhaltenden Resonanzkreis enthält, und
einem Detektor (3) zur Erzeugung eines Signals, das sich auf eine Variation einer Impedanzänderung des Sensors (1) bezieht, dadurch gekennzeichnet, daß
der Sensor (1) und der Detektor (3) aus passiven Elementen ohne Verwendung von aktiven Elementen bestehen.

2. Sensorvorrichtung nach Anspruch 1, bei welcher der Resonanzkreis eine um einen torischen Kern (15) gewickelte Spule (11) enthält.

3. Sensorvorrichtung nach Anspruch 1, bei welcher der Sensor (1) ferner einen Transformator (13) zur Versorgung des Resonanzkreises mit Spannung enthält und der Resonanzkreis eine Nachweisspule (11) zum Abfühlen eines Zustandes in der Nähe der Nachweisspule (11) und einen mit der Nachweisspule (11) in Reihe oder parallel geschalteten Kondensator (12) enthält.

4. Abfühlvorrichtung nach Anspruch 1, wobei das Hochfrequenzsignal als solches Hochfrequenzsignal ausgelegt ist, daß ein Unterschied in den Ausgaben des Detektors (3) bei Vorhandensein und Fehlen eines bestimmten nicht-magnetischen Materials oder Substanz in Nähe des Sensors (1) gegeben ist.

5. Sensorvorrichtung nach Anspruch 4, bei welcher die Frequenz zwischen 10 MHz und 300 MHz liegt.

6. Sensorvorrichtung nach Anspruch 1, bei welcher der Resonanzkreis so angeordnet ist, daß er durch die magnetische Permeabilität eines Materials oder einer Substanz in der Nähe beeinflußt wird, und der Detektor (3) eine Veränderung des durch die magnetische Permeabilität des externen Materials oder der externen Substanz in der Nähe beeinflußten Resonanzkreises nachweist.

7. Sensorvorrichtung nach Anspruch 1, bei welcher der Resonanzkreis eine solche Resonanzfrequenz hat, daß eine Signalfrequenz des Oszillators (2) auf einer steilen Neigung einer Resonanzcharakteristik angeordnet ist und daß das vom Detektor (3) erzeugte Signal sich auf einen externen Zustand in der Nähe des Sensors (1) bezieht.

8. Sensorvorrichtung nach Anspruch 1, bei welcher der Resonanzkreis resoniert und die Imaginärzahl der Impedanz um null herum eingestellt ist, wenn ein externer Nachbarzustand Referenzzustand ist, und daß das vom Detektor (3) erzeugte Signal sich auf eine Zunahme der Imaginärzahl der Impedanz des Sensors (3) bezieht.

9. Sensorvorrichtung nach Anspruch 1, bei welcher der Detektor (3) so eingerichtet ist, daß er eine reflektierte Welle, die Maßgabe eines externen Zustands in der Nähe des Sensors reflektiert ist, nachweist und das durch den Detektor (3) erzeugte Signal sich auf die reflektierte Welle bezieht.

10. Sensorvorrichtung nach Anspruch 9, bei welcher der Detektor (3) so eingerichtet ist, daß er eine Phasenverschiebung der reflektierten Welle gegenüber dem durch den Oszillator (2) erzeugten Hochfrequenzsignal nachweist.

11. Sensorvorrichtung nach Anspruch 9, bei welcher der Detektor (3) so eingerichtet ist, daß er Leistung der reflektierten Welle in Spannung zur Erzeugung der Umwandlungsspannung umwandelt.

12. Sensorvorrichtung nach Anspruch 1, bei welcher der Detektor (3) mit dem Oszillator (2) und dem Sensor (1) für ein Trennen einer Einfallswelle vom Oszillator (2) von einer reflektierten Welle vom Sensor (1) verschaltet ist, um so jeweils diesen entsprechende Signale zu erzeugen.

13. Sensorvorrichtung nach Anspruch 12, welche ferner
einen mit einem Paar von Ausgängen des Detektors (3a) verbundenen Prozessor (50a) zur Erzeugung eines Ausgangssignals, das sich auf ein Verhältnis zwischen der Einfallswelle vom Oszillator (2) und der reflektierten Welle vom Sensor (1) bezieht, aufweist.

14. Sensorvorrichtung nach Anspruch 1, welche ferner
ein einen Widerstand (105) verwendendes Dämpfungsglied (10) zwischen dem Detektor (3) und dem Oszillator (2) aufweist.

15. Sensorvorrichtung nach Anspruch 14, bei welcher das Dämpfungsglied (10) so ausgelegt ist, daß es 50 % einer Ausgabe des Oszillators (2) verbraucht.

16. Sensorvorrichtung nach Anspruch 1, welche ferner
eine Gegenkopplungsschaltung (90) zwischen dem Sensor (3) und dem Oszillator (2) verbraucht.

17. Sensorvorrichtung nach Anspruch 1, welche ferner
Beurteilungsmittel (52) zur Diskriminierung des Ausgangssignals des Sensors (1) für eine Beurteilung des Vorhandenseins oder Fehlens einer bestimmten Flüssigkeit aufweist.

18. Sensorvorrichtung nach Anspruch 1, welche ferner
einen Grenzdetektor (50) zur Feststellung eines Änderungspunkts eines Reflektionssignals des Sensors (1) beruhend auf dem Signal des Detektors (3) zur Feststellung einer Grenze einer Substanz aufweist.

19. Sensorvorrichtung nach Anspruch 1, welche ferner
einen Pulverdetektor (50a) zur Diskriminierung des Ausgangssignals des Sensors (1) an einem Niveau für eine Beurteilung des Vorhandenseins oder Fehlens eines Pulvers aufweist.

20. Sensorvorrichtung nach Anspruch 1, bei welcher der Detektor (3) für einen Nachweis eines Pulvers mit hygroskopischem Verhalten, das in der Nähe des Sensors angeordnet ist, und einer reflektierten Welle des Sensors (2) eingerichtet ist, um so ein Signal zu erzeugen, welches sich auf die reflektierte Welle bezieht, wobei die Sensorvorrichtung ferner
einen Prozessor (50 und 50a) zur Umwandlung des Ausgangssignals des Detektors in Feuchtigkeit aufweist.

21. Sensorvorrichtung nach Anspruch 1, welche ferner
einen Prozessor (50) zur Umwandlung des Ausgangssignals des Detektors in eine Lösungsproduktkonzentration und
eine Anzeige (60) zur Anzeige des Ausgangssignals des Prozessors aufweist.

22. Sensorvorrichtung nach Anspruch 21, welche ferner
einen Temperatursensor (70) zum Abfühlen von Temperatur einer Flüssigkeit aufweist, wobei der Prozessor (50) die Konzentration bezüglich Temperatur beruhend auf einer Ausgabe des Temperatursensors (70) kompensiert.

23. Sensorvorrichtung nach Anspruch 1, bei welcher der Detektor (3) so eingerichtet ist, daß er eine reflektierte Welle, die von einer in der Nähe des Sensors (1) angeordneten temperaturabhängigen Wasserlösung reflektiert wird, nachweist, um ein Signal zu erzeugen, das sich auf die reflektierte Welle bezieht, wobei die Sensorvorrichtung ferner
einen Prozessor (50) zur Umwandlung des auf die Temperatur der Wasserlösung bezüglichen Ausgangssignals in Temperatur und
eine Anzeige (60) zur Anzeige eines vom Prozessor (50) erzeugten Ausgangssignals aufweist.

24. Sensorvorrichtung nach Anspruch 1, welche ferner
einen Controller (50) zur Feststellung einer Substanz beruhend auf einem von dem Detektor (3) erzeugten Ausgangssignal und der vom Oszillator (2) erzeugten Oszillationsfrequenz aufweist.

25. Substanzsensorvorrichtung nach Anspruch 24, bei welcher eine Spule (11) des Resonanzkreises eine Luftspule mit wenigstens einer Wicklung ist.

26. Substanzsensorvorrichtung nach Anspruch 24, bei welcher eine Spule (11) der Resonanzschaltung um ein magnetisches Element (18) gewickelt ist.

27. Substanzsensorvorrichtung nach Anspruch 24, bei welcher der Resonanzkreis mehrere Spulen (11a, 11b) enthält.

28. Sensorvorrichtung nach Anspruch 1, welche ferner
einen Controller (50) zur Identifizierung des menschlichen Körpers und von anderen Substanzen beruhend auf einem von dem Detektor (3) erzeugten Ausgangssignal und der vom Oszillator (2) erzeugten Oszillationsfrequenz aufweist.

29. Sensorvorrichtung nach Anspruch 28, bei welcher der Resonanzkreis eine in einem Sitz (61) angebrachte Spule (11) aufweist.

30. Sensor nach Anspruch 28, bei welchem der Resonanzkreis eine in einem Kissen (62) angebrachte Spule (11) aufweist.

31. Substanzsensor nach Anspruch 28, 29 oder 30, bei welchem die Spule (11) aus einem bei einem Hochfrequenzsignal gut leitenden Material besteht.

32. Sensorvorrichtung nach Anspruch 1, bei welcher der Sensor (11) eine so angeordnete Spule aufweist, daß sie durch die Permeabilität eines Materials oder einer Substanz in der Nähe des Sensors beeinflußt wird, wobei die Sensorvorrichtung ferner
einen Detektor (3) zum Nachweis einer Veränderung im durch die Permeabilität eines Materials oder einer Substanz, das bzw. die in der Nähe des Sensors (1) extern vorliegt, beeinflußten Resonanzkreis für eine Erzeugung eines sich auf die Änderung beziehenden Signals aufweist,
wobei der Sensor (1) mit dem Oszillator (2) und dem Detektor (3) über ein Kabel verbunden und gesondert getrennt von dem Oszillator (2) und dem Detektor (3) ist.

## Revendications

1. Un dispositif capteur comprenant
un oscillateur (2) pour engendrer un signal de haute fréquence,
un capteur (1) qui inclut un circuit de résonance recevant de l'oscillateur (2) ledit signal à haute fréquence, et
un détecteur (3) pour produire un signal lié à une variation d'une modification d'impédance dudit capteur (1),
caractérisé en ce que
ledit capteur (1) et ledit détecteur (3) consistent en éléments passifs sans employer aucun élément actif.

2. Un dispositif capteur selon la revendication 1, dans lequel ledit circuit de résonance inclut une bobine (11) enroulée autour d'un noyau toroïdal (15).

3. Un dispositif capteur selon la revendication 1, dans lequel ledit capteur (1) inclut en outre un transformateur (13) pour alimenter en énergie ledit circuit de résonance et ledit circuit de résonance inclut une bobine de détection (11) pour capter un état au voisinage de la bobine de détection (11) et un condensateur (12) connecté en série ou en parallèle avec la bobine de détection (11).

4. Un dispositif capteur selon la revendication 1, ledit signal de haute fréquence étant conçu pour être d'une haute fréquence appropriée pour qu'il existe une différence entre les sorties dudit détecteur (3) en la présence et en l'absence d'une matière ou substance non magnétique prédéterminée près du capteur (1).

5. Un dispositif capteur selon la revendication 4, dans lequel ladite fréquence est comprise entre 10 MHz et 300 MHz.

6. Un dispositif capteur selon la revendication 1, dans lequel ledit circuit de résonance est disposé de façon à être influencé par la perméabilité magnétique d'une matière ou d'une substance voisine, et ledit détecteur (3) détecte une variation dudit circuit de résonance influencé par la perméabilité magnétique de la matière ou substance externe proche.

7. Un dispositif capteur selon la revendication 1, dans lequel la fréquence de résonance dudit circuit de résonance est telle qu'une fréquence du signal dudit oscillateur (2) est positionnée sur une pente raide d'une caractéristique de résonance, et que le signal produit par ledit détecteur (3) est lié à un état externe à proximité dudit capteur (1).

8. Un dispositif capteur selon la revendication 1, dans lequel ledit circuit de résonance résonne et la partie imaginaire de ladite impédance est fixée de manière à être proche de zéro lorsqu'un état externe au voisinage est un état de référence, et le signal produit par ledit détecteur (3) est lié à une augmentation de la partie imaginaire de ladite impédance du capteur (3).

9. Un dispositif capteur selon la revendication 1, dans lequel ledit détecteur (3) est apte à détecter une onde réfléchie qui est réfléchie conformément à un état externe au voisinage dudit capteur, et le signal produit par ledit détecteur (3) est lié à ladite onde réfléchie.

10. Un dispositif capteur selon la revendication 9, dans lequel ledit détecteur (3) est apte à détecter un déphasage de ladite onde réfléchie par rapport audit signal de haute fréquence produit par ledit oscillateur (2).

11. Un dispositif capteur selon la revendication 9, dans lequel ledit détecteur (3) est apte à convertir la puissance de ladite onde réfléchie en une tension pour engendrer la tension convertie.

12. Un dispositif capteur selon la revendication 1, dans lequel ledit détecteur (3) est connecté audit oscillateur (2) et audit capteur (1) pour séparer une onde incidente provenant dudit oscillateur (2) et une onde réfléchie provenant du capteur (1), afin de produire respectivement des signaux qui leur correspondent respectivement.

13. Un dispositif capteur selon la revendication 12, qui comprend en outre
un processeur (50a) connecté à une paire de sorties dudit détecteur (3a) pour produire un signal de sortie lié à un rapport entre ladite onde incidente provenant dudit oscillateur (2) et ladite onde réfléchie provenant dudit capteur (1).

14. Un dispositif capteur selon la revendication 1, qui comprend en outre
un atténuateur (10) qui emploie une résistance (105) interposée entre ledit détecteur (3) et ledit oscillateur (2).

15. Un dispositif capteur selon la revendication 14, dans lequel ledit atténuateur (10) est réalisé de façon à consommer 50% d'une sortie dudit oscillateur (2).

16. Un dispositif capteur selon la revendication 1, qui comprend en outre
un circuit (90) de rétroaction négative interposé entre ledit capteur (3) et ledit oscillateur (2).

17. Un dispositif capteur selon la revendication 1, qui comprend en outre
un moyen d'évaluation (52) pour discriminer ledit signal de sortie dudit capteur (1) afin d'évaluer la présence ou l'absence d'un liquide prédéterminé.

18. Un dispositif capteur selon 1 a revendication 1, qui comprend en outre
un détecteur (50) de limite afin de détecter sur la base dudit signal provenant dudit détecteur (3) un point de variation d'un signal de réflexion provenant dudit capteur (1) afin de détecter une limite d'une substance.

19. Un dispositif capteur selon la revendication 1, qui comprend en outre
un détecteur (50a) de poudre pour discriminer ledit signal de sortie provenant dudit capteur (1) à un niveau afin d'évaluer la présence ou l'absence d'une poudre.

20. Un dispositif capteur selon la revendication 1, dans lequel ledit détecteur (3) est apte à détecter une poudre hygroscopique disposée près dudit capteur et une onde réfléchie dudit capteur (2) pour engendrer un signal lié à ladite onde réfléchie, ledit dispositif capteur comprenant en outre
un processeur (50 et 50a) pour convertir en humidité ledit signal de sortie dudit détecteur.

21. Un dispositif capteur selon la revendication 1, qui comprend en outre
un processeur (50) pour convertir en une concentration de soluté ledit signal de sortie dudit détecteur, et
un affichage (60) pour afficher ledit signal de sortie dudit processeur.

22. Un dispositif capteur selon la revendication 21 qui comprend en outre
un capteur (70) de température pour capter une température de liquide, ledit processeur (50) compensant ladite concentration en fonction de la température sur la base d'une sortie dudit capteur (70) de température.

23. Un dispositif capteur selon la revendication 1, dans lequel ledit détecteur (3) est apte à détecter une onde réfléchie qui est réfléchie par une solution aqueuse dépendant la température disposée près dudit capteur (1) afin de produire un signal lié à ladite onde réfléchie, ledit dispositif capteur comprenant en outre
un processeur (50) pour convertir en température ledit signal de sortie lié à ladite température de ladite solution aqueuse, et
un affichage (60) pour afficher un signal de sortie produit par ledit processeur (50).

24. Un dispositif capteur selon la revendication 1 comprenant en outre:
un dispositif de commande (50) pour détecter une substance sur la base d'un signal de sortie produit par ledit détecteur (3) et de ladite fréquence d'oscillation engendrée par ledit oscillateur (2).

25. Un dispositif capteur de substance selon la revendication 24, dans lequel une bobine (11) dudit circuit de résonance est une bobine à noyau d'air à une spire au moins.

26. Un dispositif capteur de substance selon la revendication 24, dans lequel une bobine (11) dudit circuit de résonance est enroulée autour d'un organe magnétique (18).

27. Un dispositif capteur de substance selon la revendication 24, dans lequel ledit circuit de résonance inclut plusieurs bobines (11a et 11b).

28. Un dispositif capteur selon la revendication 1, qui comprend en outre
un dispositif de commande (50) pour identifier en vue d'une détection ledit corps humain et d'autres substances, sur la base d'un signal de sortie produit par ledit détecteur (3) et de ladite fréquence d'oscillation engendrée par ledit oscillateur (2).

29. Un dispositif capteur selon la revendication 28, dans lequel ledit circuit de résonance comprend une bobine (11) installée à l'intérieur d'un logement (61).

30. Un capteur selon la revendication 28, dans lequel ledit circuit de résonance comprend une bobine (11) installée à l'intérieur d'un coussin (62).

31. Un capteur de substance selon l'une quelconque des revendications 28 à 30, dans lequel ladite bobine (11) est en une matière à bonne conductivité pour un signal à haute fréquence.

32. Un dispositif capteur selon la revendication 1, dans lequel ledit capteur (1) inclut une bobine (11) disposée de façon à être influencée par ladite perméabilité d'une matière ou substance proche du capteur, ledit dispositif capteur comprenant en outre
un détecteur (3) pour détecter une variation dudit circuit de résonance influencé par une perméabilité d'une matière ou substance existant à l'extérieur près dudit capteur (1) afin de produire un signal lié à ladite variation,
ledit capteur (1) étant connecté audit oscillateur (2) et audit détecteur (3) par l'intermédiaire d'un câble et étant isolé séparément dudit oscillateur (2) et dudit détecteur (3).
